# EUROPÄISCHE PATENTSCHRIFT

(11) **EP 3 457 452 B1**
(45) Veröffentlichungstag und Bekanntmachung des Hinweises auf die Patenterteilung: **02.11.2022**
(21) Anmeldenummer: 18201786.3
(22) Anmeldetag: 13.09.2007
(51) Int. Cl.: H01L 51/54, C09K 11/06

(54) **OLED-ANZEIGE MIT VERLÄNGERTER LEBENSDAUER**
OLED DISPLAY WITH EXTENDED LIFETIME
AFFICHAGE DELO À DURÉE DE VIE PROLONGÉE

(30) Priorität: 21.09.2006 EP 06121077; 05.07.2007 EP 07111816
(43) Veröffentlichungstag der Anmeldung: 20.03.2019
(62) Teilanmeldung aus: 07803464.2
(73) Patentinhaber: UDC Ireland Limited, Ballycoolin, Dublin 15 (IE)
(72) Erfinder: SCHILDKNECHT, Christian, 68305 Mannheim (DE); FUCHS, Evelyn, 68199 Mannheim (DE); LANGER, Nicolle, 68163 Mannheim (DE); KAHLE, Klaus, 67069 Ludwigshafen (DE); LENNARTZ, Christian, 67105 Schifferstadt (DE); MOLT, Oliver, 69493 Hirschberg (DE); WAGENBLAST, Gerhard, 67157 Wachenheim (DE); RUDOLPH, Jens, 67547 Worms (DE)
(74) Vertreter: Hansen, Norbert

(56) Entgegenhaltungen:
- WO-A-2005/019373
- WO-A2-2005/019373
- JP-A- 2004 103 463
- JP-A- 2004 253 298
- US-A1- 2005 260 447
- PETER ERK ET AL: "11.2: Efficient Deep Blue Triplet Emitters for OLEDs", SID 2006, 2006 SID INTERNATIONAL SYMPOSIUM, SOCIETY FOR INFORMATION DISPLAY, LO, Bd. XXXVII, Juni 2006 (2006-06), Seiten 131-133, XP007012644, ISSN: 0006-966X

## Beschreibung

Die vorliegende Erfindung betrifft eine organische Leuchtdiode, die eine Licht-emittierende Schicht C aufweist, die mindestens ein Loch-leitendes Material CA und mindestens einen Phosphoreszenz-Emitter CB enthält
zur Verlängerung der Lebensdauer der Licht-emittierenden Schicht. Die erfindungsgemäße organische Leuchtdiode weist
in der Loch-blockierenden Schicht
mindestens eine Verbindung ausgewählt aus Disilylcarbazolen, Disilyldibenzofuranen, Disilyldibenzothiophenen, Disilyldibenzophospholen, Disilyldibenzothiophen-S-oxiden und Disilyldibenzothiophen-S,S-dioxiden auf.

In organischen Leuchtdioden (OLED) wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristall-Displays zur Herstellung von Flachbildschirmen. Aufgrund der sehr kompakten Bauweise und des intrinsisch niedrigen Stromverbrauchs eignen sich Vorrichtungen enthaltend OLEDs insbesondere für mobile Anwendungen, z. B. für Anwendungen in Handys, Laptops, u.s.w.

Die Grundprinzipien der Funktionsweise von OLEDs sowie geeignete Aufbauten (Schichten) von OLEDs sind dem Fachmann bekannt und z. B. in WO 2005/113704 und der darin zitierten Literatur genannt. Als Licht-emittierende Materialien (Emitter) können neben fluoreszierenden Materialien (Fluoreszenz-Emitter) phosphoreszierende Materialien (Phosphoreszenz-Emitter) eingesetzt werden. Bei den Phosphoreszenz-Emittern handelt es sich üblicherweise um metallorganische Komplexe, die im Gegensatz zu den Fluoreszenz-Emittern, die eine Singulett-Emission zeigen, eine Triplett-Emission zeigen (M. A. Baldow et al., Appl. Phys. Lett. 1999, 75, 4 bis 6). Aus quantenmechanischen Gründen ist bei Verwendung der Phosphoreszenz-Emitter eine bis zu vierfache Quanten-, Energie- und Leistungseffizienz möglich. Um die Vorteile des Einsatzes der metallorganischen Phosphoreszenz-Emitter in die Praxis umzusetzen, ist es erforderlich, Phosphoreszenz-Emitter sowie Device-Kompositionen bereitzustellen, die eine hohe operative Lebensdauer, eine hohe Stabilität gegenüber Temperaturbelastung und eine niedrige Einsatz- und Betriebsspannung aufweisen.

Um den vorstehend genannten Anforderungen zu genügen, sind zahlreiche Phosphoreszenz-Emitter sowie Device-Kompositionen im Stand der Technik vorgeschlagen worden.

So betrifft WO 2005/019373 erstmals die Verwendung von neutralen Übergangsmetallkomplexen, die mindestens einen Carbenliganden enthalten, in OLEDs. Diese Übergangsmetallkomplexe können gemäß WO 2005/019373 in jeder Schicht eines OLEDs eingesetzt werden, wobei das Ligandgerüst oder Zentralmetall zur Anpassung an gewünschte Eigenschaften der Übergangsmetallkomplexe variiert werden kann. Beispielsweise ist der Einsatz der Übergangsmetallkomplexe in einer Blockschicht für Elektronen, einer Blockschicht für Excitonen, einer Blockschicht für Löcher oder der Licht-emittierenden Schicht des OLEDs möglich, wobei die Übergangsmetallkomplexe bevorzugt als Emittermoleküle in OLEDs eingesetzt werden.

WO 2005/113704 betrifft lumineszente Verbindungen, die Carbenliganden tragen. Gemäß WO 2005/113704 sind zahlreiche Übergangsmetallkomplexe mit verschiedenen Carbenliganden genannt, wobei die Übergangsmetallkomplexe bevorzugt als phosphoreszierendes Licht-emittierendes Material, besonders bevorzugt als Dotiersubstanz eingesetzt werden.

In US 5,668,438 ist eine organische Leuchtdiode offenbart, aufgebaut aus einer Kathode, einer Elektronentransportschicht, einer Lochtransportschicht und einer Anode, wobei die Elektronen- und die Lochtransportschicht so ausgewählt sind, dass sichergestellt ist, dass die Lichtemission in der Lochtransportschicht der organischen Leuchtdiode erfolgt. In einer Ausführungsform in US 5,668,438 wird die Lochtransportschicht mit einem Fluoreszenz-Material dotiert. Der Einsatz von Phosphoreszenz-Materialien ist in US 5,668,438 nicht erwähnt. Die organische Leuchtdiode gemäß US 5,668,438 zeichnet sich insbesondere durch eine verbesserte Effizienz gegenüber üblichen organischen Leuchtdioden aus. In US 5,668,438 wird beispielhaft der Einsatz eines grün fluoreszierenden Lochtransportmaterials mit einer typischen Bandlücke von 2,50 eV erwähnt, das gemeinsam mit einem blau fluoreszierenden Elektronentransportmaterial mit einer typischen Bandlücke von 2,75 eV eingesetzt wird.

DE-A 103 55 380 betrifft Materialmischungen enthaltend mindestens ein Matrixmaterial, das eine bestimmte Struktureinheit L = X und/oder M = X aufweist, wobei der Rest X mindestens ein nicht-bindendes Elektronenpaar aufweist, der Rest L für P, As, Sb oder Bi steht, der Rest M für S, Se oder Te steht, und mindestens ein zur Emission befähigtes E-missionsmaterial, welches eine Verbindung ist, die bei geeigneter Anregung Licht emittiert und mindestens ein Element der Ordnungszahl > 20 enthält. Die Mischungen können in elektronischen Bauteilen, insbesondere in OLEDs eingesetzt werden und führen gemäß DE-A 103 55 380 zu einer Verbesserung in Bezug auf die Effizienz in Kombination mit einer stark erhöhten Lebensdauer. Es wird darauf hingewiesen, dass mit den Mischungen gemäß DE-A 103 55 380 ein deutlich vereinfachter Schichtaufbau der OLED möglich ist, da weder eine separate Lochblockierschicht, noch eine separate Elektronentransport- und/oder Elektroneninjektionsschicht verwendet werden muss. Gemäß den Beispielen wird eine OLED mit bis (9,9'-Spiro-bifluoren-2-yl)phenylphosphinoxid als Wirtsmaterial, die mit Ir(PPy)₃ als Emitter dotiert ist, eingesetzt, wobei die OLED eine grüne Emission zeigt.

In JP 2004 253298 A und JP 2004 103463 A werden organische Leuchtdioden offenbart, welche eine Licht-emittierende Schicht mit CBP als lochleitendem Material umfassen.

In US 2005/0260447 A1 ist eine organische Leuchtdiode offenbart welche eine Licht-emittierende Schicht mit Übergangsmetallkomplexen, die mindestens einen Carbenliganden enthalten, als Matrixmaterialien verwendet. ERK et al ("11.2: Efficient Deep Blue Triplet Emitters for OLEDs",SID 2006, 2006 SID INTERNATIONAL SYMPOSIUM, SOCIETY FOR INFORMATION DISPLAY, LO, Bd. XXXVII, Juni 2006 (2006-06), Seiten 131-133) beschreiben Iridiumkomplexe mit drei Carbenliganden als blaue Phosphoreszenz-Emitter für organische Leuchtdioden.

Es besteht weiterhin Bedarf an organischen Leuchtdioden, die sich neben einer guten Effizienz und einer niedrigen Einsatz- und Betriebsspannung durch eine besonders hohe operative Lebensdauer auszeichnen. Dabei ist insbesondere der Bedarf an blaues Licht emittierenden OLEDs sehr hoch.

Aufgabe der vorliegenden Erfindung ist daher die Bereitstellung von organischen Leuchtdioden (OLEDs) sowie Materialien, die in der Emitterschicht in organischen Leuchtdioden eingesetzt werden können, die sich insbesondere durch eine hohe operative Lebensdauer auszeichnen, und bevorzugt im blauen Bereich des elektromagnetischen Spektrums Licht emittieren.

Diese Aufgabe wird gelöst durch eine organische Leuchtdiode (OLED) gemäß Anspruch 1.

Die erfindungsgemäße organische Leuchtdiode (OLED) ist dann dadurch gekennzeichnet, dass die Licht-emittierende Schicht mindestens ein Loch-leitendes Material CA und mindestens einen Phosphoreszenz-Emitter CB enthält.

Es wurde überraschenderweise gefunden, dass die Lebensdauer der Licht-emittierenden Schicht einer OLED enthaltend mindestens ein Loch-leitendes Material CA gemeinsam mit mindestens einem Phosphoreszenz-Emitter CB gegenüber einer Licht-emittierenden Schicht, die kein Loch-leitendes Material enthält, um das bis zu 100-fache verlängert werden kann.

### Anode A

Als Anodenmaterial für die Anode A können alle dem Fachmann bekannten Anodenmaterialien eingesetzt werden. Geeignete Materialien für die Anode sind beispielsweise Materialien, die ein Metall, eine Mischung verschiedener Metalle, eine Metalllegierung, ein Metalloxid oder eine Mischung verschiedener Metalloxide enthalten. Alternativ kann die Anode ein leitendes Polymer sein. Geeignete Metalle sind z. B. Metalle der Gruppen IB, IIB, IVB, VB, VIB, VIII, IVA und IVB des Periodensystems der Elemente (CAS-Version). Wenn die Anode lichtdurchlässig sein soll, werden im Allgemeinen gemischte Metalloxide der Gruppen IIB, IIIA und IVA des Periodensystems der Elemente (CAS-Version) eingesetzt, insbesondere Indium-Zinn-Oxid (ITO), was besonders bevorzugt ist. Es ist ebenfalls möglich, dass die Anode A ein organisches Material, z. B. Polyanilin enthält, wie beispielsweise in Nature, Vol. 357, Seite 477 bis 479 (11. Juni 1992) beschrieben ist. Zumindest entweder die Anode oder die Katode sollten mindestens teilweise transparent sein, um das in der Licht-emittierenden Schicht gebildete Licht auskoppeln zu können.

### Loch-leitende Schicht B und Licht-emittierende Schicht C

### Loch-leitende Materialien B und CA

Die Loch-leitende Schicht B ist aus mindestens einem Loch-leitenden Material aufgebaut. Die Licht-emittierende Schicht C enthält erfindungsgemäß neben mindestens einem Phosphoreszenz-Emitter CB ebenfalls mindestens ein Loch-leitendes Material CA. Die Loch-leitenden Materialien in der Licht-emittierenden Schicht C und der Loch-leitenden Schicht B können gleich oder verschieden sein.

Bevorzugt weist das HOMO des mindestens einen Loch-leitenden Materials der Loch-leitenden Schicht B sowie das HOMO des mindestens einen Loch-leitenden Materials CA der Licht-emittierenden Schicht C einen Abstand zu der Austrittsarbeit der Anode von ≤ 1 eV, bevorzugt im Bereich von etwa ≤ 0,5 eV auf. Wird beispielsweise als Anodenmaterial ITO eingesetzt, dessen Austrittsarbeit etwa bei 5 eV liegt, wird als Loch-leitendes Material in der Schicht B sowie als Loch-leitendes Material CA in der Schicht C bevorzugt ein Material eingesetzt, dessen HOMO bei ≤ 6 eV liegt, bevorzugt im Bereich von 5 bis 6 eV.

Als Loch-leitende Materialien können in den Schichten C und B alle geeigneten dem Fachmann bekannten Loch-leitenden Carbenkomplexe eingesetzt werden. Die Bandlücke des mindestens einen Loch-leitenden Materials sowohl der Loch-leitenden Schicht B als auch der Licht-emittierenden Schicht C ist größer als die Bandlücke des mindestens einen in der Licht-emittierenden Schicht C eingesetzten Phosphoreszenz-Emitters CB.

Unter Bandlücke ist im Sinne der vorliegenden Anmeldung die Triplettenergie zu verstehen.

Übliche Loch-leitende Materialien sind z. B. in Kirk-Othmer, Encyclopedia of Chemical Technology, 4. Aufl., Vol. 18, Seiten 837 bis 860, 1996, offenbart. Sowohl Löcher-transportierende Moleküle als auch Polymere können als Loch-leitende Materialien eingesetzt werden. Üblicherweise eingesetzte Loch-leitende Materialien sind ausgewählt aus der Gruppe bestehend aus 4,4'-Bis[N-(1-naphthyl)-N-phenyl-amino]biphenyl (a-NPD), N,N'-Diphenyl-N,N'-bis(3-methylphenyl)-[1,1'-biphenyl]-4,4'-diamin (TPD), 1,1-Bis[(di-4-tolylamino)-(3,3'-dimethyl)biphenyl]-4,4'-diamin (ETPD), Tetrakis-(3-methylphenyl)-N,N,N',N'-2,5-phenylindiamin (PDA), α-Phenyl-N,N-diphenylaminostyrol (TPF), p-(Diethylamino)-benzaldehyddiphenylhydrazon (DEH), Triphenylamin (TPA), Bis-[4-(N,N-diethylamino)-2-methylphenyl](4-methyl-phenyl)methan (MPMP), 1-Phenyl-3-[p-(diethylamino)styryl]-5-[p-(diethylaminophenyl]pyrazolin (PPR oder DEASP), 1,2-trans-Bis(9H-carbazol-9-yl)cyclobutan (DCZB), N,N,N',N'-tetrakis(4-Methylphenyl)-(1,1'-biphenyl)-4,4'-diamin (TTB), 4,4',4"-tris(N,N-Diphenylamino)triphenylamin (TDTA) und Porphyrin-Verbindungen sowie Phthalocyaninen wie Kupferphthalocyanine. Üblicherweise eingesetzte Löcher-transportierende Polymere sind ausgewählt aus der Gruppe bestehend aus Polyvinylcarbazolen (Phenylmethyl)polysilanen, PEDOT (Poly(3,4-ethylendioxythiophen), bevorzugt PEDOT, dotiert mit PSS (Polystyrolsulfonat), und Polyanilinen. Es ist ebenfalls möglich, Löcher-transportierende Polymere durch Dotieren Löchertransportierender Moleküle in Polymere wie Polystyrol und Polycarbonat zu erhalten. Geeignete Löcher-transportierende Moleküle sind die bereits vorstehend genannten Moleküle.

Wie bereits vorstehend erwähnt, ist die Bandlücke des mindestens einen Loch-leitenden Materials der Schicht B und des mindestens einen Loch-leitenden Materials CA der Schicht C größer als die Bandlücke des mindestens einen Phosphoreszenz-Emitters CB.

Neben den vorstehend genannten üblichen Loch-leitenden Materialien sind als Loch-leitende Materialien für die Schicht B sowie für die Schicht C des Weiteren z.B. Übergangsmetallkomplexe geeignet, wobei auch Materialien geeignet sind, die üblicherweise als Emittermaterialien eingesetzt werden. Zum Beispiel können dabei Phosphoreszenz-Emitter als Loch-leitende Materialien in den Schichten B und C eingesetzt werden, wenn diese eine Bandlücke aufweisen, die größer ist als die Bandlücke des in der Schicht C eingesetzten Phosphoreszenz-Emitters CB. Geeignete Loch-leitende Materialien, die zu der vorstehend genannten Gruppe von Materialien gehören, sind z. B. die nachstehend als Phosphoreszenz-Emitter genannten Übergangsmetallkomplexe, soweit sie die vorstehend genannte Bedingung im Verhältnis zu dem eingesetzten Phosphoreszenz-Emitter erfüllen.

Des Weiteren sind neben den vorstehend genannten Loch-leitenden Materialien in einer weiteren Ausführungsform der vorliegenden Erfindung Disilylcarbazole und Disilylbenzophosphole der nachstehend genannten allgemeinen Formel (III) (X = NR³⁷ oder PR³⁷) als Loch-leitende Materialien für die Schicht B oder als Komponente CA in der Licht-emittierenden Schicht C geeignet.

Die in der vorliegenden Anmeldung genannten Bandlücken sowie die Energien der HOMOs und LUMOs der in der erfindungsgemäßen OLED eingesetzten Materialien können durch unterschiedliche Methoden bestimmt werden, z.B. durch Lösungselektrochemie, z.B. Cyclovoltametrie. Außerdem lässt sich die Lage des LUMO eines bestimmten Materials aus dem durch Ultraviolett-Photonen-elektronenspektroskopie (UPS) bestimmten HOMO und dem optisch durch Absorptionsspektroskopie bestimmten Bandabstand berechnen.

Die in der vorliegenden Anmeldung genannten Angaben betreffend die Lage der HOMOs und LUMOs sowie des Bandabstandes der in der erfindungsgemäßen OLED eingesetzten Materialien werden mittels UPS an den reinen Verbindungen in Form ihrer Festkörper ermittelt. UPS ist ein dem Fachmann bekanntes Verfahren und die Ermittlung der Lage der HOMOs und LUMOs sowie der Bandlücke anhand der Ergebnisse der UPS sind dem Fachmann bekannt.

### Phosphoreszenz-Emitter CB

Als Phosphoreszenz-Emitter CB in der Licht-emittierenden Schicht sind grundsätzlich alle dem Fachmann bekannten Phosphoreszenz-Emitter geeignet. Bevorzugt werden gemäß der vorliegenden Erfindung in der Licht-emittierenden Schicht C Phosphoreszenz-Emitter CB eingesetzt, die eine Bandlücke von ≥ 2,5 eV, bevorzugt 2,5 eV bis 3,4 eV, besonders bevorzugt 2,6 eV bis 3,2 eV, ganz besonders bevorzugt 2,8 eV bis 3,2 eV aufweisen. Ganz besonders bevorzugt sind somit Phosphoreszenz-Emitter, die blaues Licht emittieren. Wie bereits vorstehend erwähnt, ist die Bandlücke des in den Schichten B und C eingesetzten Loch-leitenden Materials größer als die Bandlücke des Phosphoreszenz-Emitters. Durch die vorstehende Angabe der Bandlücke des Phosphoreszenz-Emitters lässt sich die Bandlücke des bevorzugt geeigneten Loch-leitenden Materials der Schicht B sowie der Schicht C einfach ermitteln.

Bevorzugt wird in der erfindungsgemäßen OLED ein Phosphoreszenz-Emitter CB eingesetzt, der mindestens ein Element ausgewählt aus den Gruppen IB, IIB, IIIB, IVB, VB, VIB, VIIB, VIIIB, den Lanthaniden und IIIA des Periodensystems der Elemente (CAS-Version) aufweist. Bevorzugt weist der Phosphoreszenz-Emitter mindestens ein Element ausgewählt aus den Gruppen IIB, IIIB, IVB, VB, VIB, VIIB, VIII des Periodensystems der Elemente (CAS-Version), Cu und Eu auf. Ganz besonders bevorzugt weist der Phosphoreszenz-Emitter mindestens ein Element ausgewählt aus den Gruppen IB, VIB, VIIB, VIII und Eu auf, wobei das mindestens eine Element bevorzugt ausgewählt ist aus Cr, Mo, W, Mn, Tc, Re, Ru, Os, Co, Rh, Ir, Fe, Nb, Pd, Pt, Cu, Ag, Au und Eu, weiter ganz besonders bevorzugt ist das mindestens eine Element ausgewählt aus Os, Rh, Ir, Ru, Pd und Pt und insbesondere weiter ganz besonders bevorzugt ausgewählt aus Ru, Rh, Ir und Pt. In einer weiteren insbesondere ganz besonders bevorzugten Ausführungsform weist der Phosphoreszenz-Emitter mindestens ein Element ausgewählt aus Ir und Pt auf.

In einer ganz besonders bevorzugten Ausführungsform handelt es sich bei dem mindestens einen Loch-leitenden Material CA in der Schicht C und bei dem Phosphoreszenz-Emitter CB um einen Carbenkomplex. Bei dem Loch-leitenden Material der Loch-leitenden Schicht B handelt es sich ebenfalls um einen Carbenkomplex . Bevorzugt sind dabei Carbenkomplexe, die mindestens eines der vorstehend genannten Elemente aufweisen. Werden sowohl als Loch-leitende Materialien als auch als Phosphoreszenz-Emitter Carbenkomplexe eingesetzt, so handelt es sich bei den eingesetzten Carbenkomplexen um verschiedene Carbenkomplexe, wobei die Bandlücke des als Loch-leitendes Material eingesetzten Carbenkomplexes größer ist als die Bandlücke des als Phosphoreszenz-Emitter eingesetzten Carbenkomplexes. Die als Loch-leitendes Material CA in der Licht-emittierenden Schicht eingesetzten Carbenkomplexe und die als Loch-leitendes Material in der Loch-leitenden Schicht B eingesetzten Carbenkomplexe können gleich oder verschieden sein.

Der als Phosphoreszenz-Emitter in der Licht-emittierenden Schicht bevorzugt eingesetzte Carbenkomplex weist in einer bevorzugten Ausführungsform eine Bandlücke von ≥ 2,5 eV, bevorzugt 2,5 eV bis 3,4 eV, besonders bevorzugt 2,6 eV bis 3,2 eV, ganz besonders bevorzugt 2,8 eV bis 3,2 eV auf. Insbesondere bevorzugt handelt es sich bei dem als Phosphoreszenz-Emitter CB eingesetzten Carbenkomplex um eine blaues Licht-emittierende Verbindung.

Bevorzugt als Phosphoreszenz-Emitter CB in der Licht-emittierenden Schicht C bzw. als Loch-leitendes Material CA in der Schicht C oder als Loch-leitendes Material in der Schicht B eingesetzte Carbenkomplexe weisen die allgemeine Formel I auf: 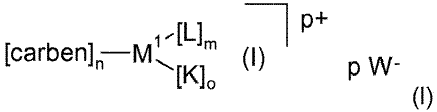 worin die Symbole die folgende Bedeutung aufweisen:
- M¹: Metallatom ausgewählt aus der Gruppe bestehend aus Übergangsmetallen der Gruppe IB, IIB, IIIB, IVB, VB, VIB, VIIB, VIII, den Lanthaniden und IIIA des Periodensystems der Elemente (CAS-Version), in jeder für das entsprechende Metallatom möglichen Oxidationsstufe; wobei bevorzugte Metallatome die bereits vorstehend bezüglich des Phosphoreszenz-Emitters CB genannten Metallatome sind;
- carben: Carbenligand, der neutral oder monoanionisch und mono-, bi- oder tridentat sein kann; bei dem Carbenliganden kann es sich auch um einen Bis- oder Triscarbenliganden handeln;
- L: mono- oder dianionischer Ligand, bevorzugt monoanionischer Ligand, der mono- oder bidentat sein kann;
- K: neutraler mono- oder bidentater Ligand;
- n: Zahl der Carbenliganden, wobei n mindestens 1 ist, bevorzugt 1 bis 6, und die Carbenliganden in dem Komplex der Formel I bei n > 1 gleich oder verschieden sein können;
- m: Zahl der Liganden L, wobei m 0 oder ≥ 1 sein kann, bevorzugt 0 bis 5, und die Liganden L bei m > 1 gleich oder verschieden sein können;
- o: Zahl der Liganden K, wobei o 0 oder ≥ 1 sein kann, bevorzugt 0 bis 5, und die Liganden K o > 1 gleich oder verschieden sein können;
- p: Ladung des Komplexes: 0, 1,2, 3 oder 4;
- W⁻: monoanionisches Gegenion;
wobei die Summe n + m + o und die Ladung p von der Oxidationsstufe und Koordinationszahl des eingesetzten Metallatoms, der Ladung des Komplexes und von der Zähnigkeit der Liganden carben, L und K sowie von der Ladung der Liganden carben und L abhängig sind, mit der Bedingung, dass n mindestens 1 ist.

In einer besonders bevorzugten Ausführungsform der vorliegenden Erfindung handelt es sich sowohl bei dem Phosphoreszenz-Emitter CB als auch bei dem in der Loch-leitenden Schicht B eingesetzten Loch-leitenden Material und dem in der Licht-emittierenden Schicht C eingesetzten Loch-leitenden Material CA um einen Carbenkomplex der allgemeinen Formel I, wobei die Bandlücke des in der Schicht B und in der Schicht C eingesetzten Loch-leitenden Materials größer ist als die Bandlücke des Phosphoreszenz-Emitters CB.

Bevorzugt eingesetzte geeignete Carbenkomplexe der Formel I sind in WO 2005/019373, WO 2005/113704, WO 06/018292, WO 06/056418 sowie den nicht vorveröffentlichten Europäischen Anmeldungen mit den Aktenzeichen 06112198.4, 06112228.9, 06116100.6 und 06116093.3 genannt. Besonders bevorzugte Carbenkomplexe sind in WO 05/019373 und WO 06/056148 genannt. Die in den vorstehenden Dokumenten genannten Carbenkomplexe können sowohl als Loch-leitendes Material in der Loch-leitenden Schicht B oder Loch-leitendes Material CA in der Schicht C und/oder als Phosphoreszenz-Emitter CB in der Licht-emittierenden Schicht C eingesetzt werden. Dabei handelt es sich bei den Loch-leitenden Materialien, die in der Schicht B bzw. in der Schicht C eingesetzt werden können, um andere Carbenkomplexe als die als Phosphoreszenz-Emitter in der Licht-emittierenden Schicht C eingesetzten Materialien. Die als Loch-leitende Materialien eingesetzten Carbenkomplexe weisen eine größere Bandlücke auf als die als Phosphoreszenz-Emitter CB eingesetzten Carbenkomplexe, wie bereits vorstehend erwähnt wurde. Geeignete Bandlücken für bevorzugt eingesetzte Carbenkomplexe wurden ebenfalls bereits vorstehend erwähnt.

In Abhängigkeit von der Koordinationszahl des in den Carbenkomplexen der Formel I eingesetzten Metalls M¹ und der Natur und der Zahl der eingesetzten Liganden L, K und carben können verschiedene Isomere der entsprechenden Metallkomplexe bei gleichem Metall M¹ und gleicher Natur und Zahl der eingesetzten Liganden K, L und carben vorliegen. Zum Beispiel sind bei Komplexen mit einem Metall M¹ mit der Koordinationszahl 6 (also oktaedrischen Komplexen), z. B. Ir (III)-Komplexen sowohl cis/trans-Isomere möglich, wenn es sich um Komplexe der allgemeinen Zusammensetzung MA₂B₄ handelt, als auch fac-mer-Isomere (facial/meridional-Isomere), wenn es sich um Komplexe der allgemeinen Zusammensetzung MA₃B₃ handelt. Bei quadratisch planaren Komplexen mit einem Metall M¹ mit der Koordinationszahl 4, z. B. Pt (II)-Komplexen, sind cis/trans-Isomere möglich, wenn es sich um Komplexe der allgemeinen Zusammensetzung MA₂B₂ handelt. Bei den Symbolen A und B handelt es sich jeweils um eine Bindungsstelle eines Liganden, wobei nicht nur monodentate, sondern auch bidentate Liganden vorliegen können. Ein unsymmetrischer bidentater Ligand weist gemäß der vorstehend erwähnten allgemeinen Zusammensetzung eine Gruppe A und eine Gruppe B auf.

Dem Fachmann ist bekannt, was unter cis/trans- und fac-mer-Isomeren zu verstehen ist. Weitere Ausführungen bezüglich der cis/trans- bzw. fac-mer-Isomerie sind z. B. WO 05/019373 zu entnehmen.

Im Allgemeinen können die verschiedenen Isomere der Metallkomplexe der Formel I nach dem Fachmann bekannten Verfahren, z. B. durch Chromatographie, Sublimation oder Kristallisation getrennt werden.

Besonders bevorzugt weisen die Carbenkomplexe der allgemeinen Formel I ein Metallatom M¹ ausgewählt aus der Gruppe bestehend aus Ir, Os, Rh und Pt auf, wobei Os(II), Rh(III), Ir(I), Ir(III) und Pt(II) bevorzugt sind. Besonders bevorzugt wird Ir eingesetzt, bevorzugt Ir(III).

Geeignete mono- oder dianionische Liganden L, bevorzugt monoanionische Liganden L, die mono- oder bidentat sein können, sind die üblicherweise als mono- oder bidentate mono- oder dianionische Liganden eingesetzten Liganden.

Dabei werden üblicherweise als Liganden L nicht-photoaktive Liganden eingesetzt. Geeignete Liganden sind z. B. monoanionische monodentate Liganden wie Halogenide, insbesondere Cl⁻, Br⁻, I⁻, Pseudohalogenide, insbesondere CN⁻, OAc⁻, Alkylreste, die mit dem Übergangsmetallatom M¹ über eine Sigmabindung verknüpft sind, z. B. CH₃, Alkoholate, Thiolate, Amide. Geeignete monoanionische bidentate Liganden sind z. B. Acetylacetonat und dessen Derivate sowie die in WO 02/15645 genannten monoanionischen bidentaten Liganden und Oxid.

Geeignete neutrale mono- oder bidentate Liganden K sind solche Liganden, die üblicherweise als neutrale mono- oder bidentate Liganden eingesetzt werden. Im Allgemeinen handelt es sich bei den in den Übergangsmetallcarbenkomplexen der Formel I eingesetzten Liganden K um nicht photoaktive Liganden. Geeignete Liganden K sind z. B. Phosphine, insbesondere Trialkylphosphine, z.B. PEt₃, PnBu₃, Triarylphosphine, z.B. PPh₃; Phosphonate und Derivate davon, Arsenate und Derivate davon, Phosphite, CO, Nitrile, Amine, Diene, die einen π-Komplex mit M¹ bilden können, z.B. 2,4-Hexadien, η⁴-Cyclooctadien und η²-Cyclooctadien (je 1,3 und 1,5), Allyl, Methallyl, Cycloocten und Norbornadien. Des Weiteren sind als neutrale bidentate Liganden K heterocyclische Nicht-Carbenliganden geeignet, wie sie in der Europäischen Anmeldung mit dem Aktenzeichen 06112198.4 offenbart sind.

Geeignete monoanionische Gegenionen W⁻ sind z. B. Halogenid, Pseudohalogenid, BF₄⁻, PF₆⁻, AsF₆⁻, SbF₆⁻ oder OAc⁻, bevorzugt Cl⁻, Br⁻, I⁻, CN⁻, OAc⁻, besonders bevorzugt Br⁻ oder I⁻.

Die Zahl n der Carbenliganden beträgt in den Übergangsmetallcarbenkomplexen der Formel I mindestens 1, bevorzugt 1 bis 6. Dabei bezieht sich die Zahl n auf die Zahl der Verknüpfungen von Carbenkohlenstoffatomen mit dem Übergangsmetall M¹. Das bedeutet, für einen verbrückten Carbenliganden, der z.B. zwei Carbenkohlenstoffatome aufweist, die eine Verknüpfung mit dem Übergangsmetall M¹ ausbilden können, ist n = 2. Werden bidentate Carbenliganden eingesetzt, wobei die Verknüpfung zu M¹ über ein Carbenkohlenstoffatom und ein Nicht-Carbenkohlenstoffatom erfolgt, ist n = 1. Solche Carbenkomplexe sind bevorzugt und werden nachstehend näher beschrieben. Bei einem Einsatz von bidentaten Carbenkomplexen, wobei eine Verknüpfung mit M¹ über ein Carbenkohlenstoffatom und die zweite Verknüpfung mit M¹ über ein Nicht-Carbenkohlenstoffatom erfolgt, ist n bevorzugt 1 bis 3, besonders bevorzugt 2 oder 3, ganz besonders bevorzugt 3.

Die Zahl m der monoanionischen Liganden L beträgt in den Übergangsmetallcarbenkomplexen der Formel I 0 bis 5, bevorzugt 0 bis 2. Ist m > 1, können die Liganden L gleich oder verschieden sein, bevorzugt sind sie gleich.

Die Zahl der o der neutralen Liganden K in den Übergangsmetallcarbenkomplexen der Formel I beträgt 0 bis 5, bevorzugt 0 bis 3. Ist o > 1, können die Liganden K gleich oder verschieden sein, bevorzugt sind sie gleich.

Die Zahl p gibt die Ladung des Übergangsmetallkomplexes an, der neutral sein kann (p = 0) oder positiv geladen sein kann, p = 1, 2, 3 oder 4, bevorzugt 1, 2, 3, besonders bevorzugt 1 oder 2. Besonders bevorzugt ist p 0, 1 oder 2, ganz besonders bevorzugt ist p 0. Gleichzeitig gibt die Zahl p die Zahl der monoanionischen Gegenionen W⁻ an.

Handelt es sich bei dem Übergangsmetallcarbenkomplex der Formel I um einen neutralen Metallcarbenkomplex, bedeutet p = 0. Ist der Übergangsmetallcarbenkomplex positiv geladen, so entspricht die Zahl p der monoanionischen Gegenionen der positiven Ladung des Übergangsmetallcarbenkomplexes.

Die Anzahl der Liganden carben, K und L und die Zahl der monoanionischen Gegenionen W⁻, d. h. n, o, m und p, sind abhängig von der Oxidationsstufe und der Koordinationszahl des eingesetzten Metallatoms M¹ sowie von der Ladung der Liganden und der Gesamtladung des Komplexes.

Der Ligand "Carben" kann grundsätzlich ein beliebiger geeigneter Carbenligand sein, wobei die in den vorstehend genannten Dokumenten offenbarten Carbenliganden bevorzugt sind. Besonders bevorzugt weist der Carbenligand die allgemeine Formel II auf: 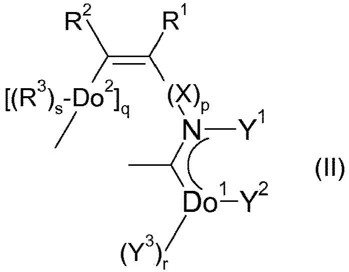 wobei die Symbole in den Carbenliganden der allgemeinen Formel II die folgenden Bedeutungen aufweisen:
- Do¹: Donoratom ausgewählt aus der Gruppe bestehend aus C, P, N, O, S und Si, bevorzugt P, N, O und S;
- Do²: Donoratom ausgewählt aus der Gruppe bestehend aus C, N, P, O und S;
- r: 2, wenn Do¹ C oder Si ist, 1, wenn Do¹ N oder P ist und 0, wenn Do¹ O oder S ist;
- s: 2, wenn Do² C ist, 1, wenn Do² N oder P ist und 0, wenn Do² O oder S ist;
- X: Spacer ausgewählt aus der Gruppe bestehend aus Silylen, Alkylen, Arylen, Heteroarylen, Alkinylen, Alkenylen, NR¹³, PR¹⁴, BR¹⁵, O, S, SO, SO₂, CO, CO-O, O-CO und (CR¹⁶R¹⁷)_{w}, wobei eine oder mehrere nicht benachbarte Gruppen (CR¹⁶R¹⁷) durch NR¹³, PR¹⁴, BR¹⁵, O, S, SO, SO₂, CO, CO-O, O-CO ersetzt sein können;
- w: 2 - 10;
- R¹³, R¹⁴, R¹⁵, R¹⁶, R¹⁷: H, Alkyl, Aryl, Heteroaryl, Alkenyl, Alkinyl;
- p: 0 oder 1,
- q: 0 oder 1;
- Y¹, Y²: jeweils unabhängig voneinander Wasserstoff, oder eine Kohlenstoff-haltige Gruppe ausgewählt aus der Gruppe bestehend aus Alkyl-, Aryl-, Heteroaryl-, Alkinyl- und Alkenylgruppen;
oder
Y¹ und Y² bilden gemeinsam eine Brücke zwischen dem Donoratom Do¹ und dem Stickstoffatom N, die mindestens zwei Atome aufweist, wovon mindestens eines ein Kohlenstoffatom ist;
R¹, R² unabhängig voneinander Wasserstoff, Alkyl-, Aryl-, Heteroaryl-, Alkinyl- oder Alkenylreste,
oder
R¹ und R² bilden gemeinsam eine Brücke mit insgesamt 3 bis 5 Atomen, wovon 1 bis 5 Atome Heteroatome sein können und die restlichen Atome Kohlenstoffatome sind, so dass die Gruppe 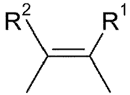 einen 5- bis 7-gliedrigen Ring bildet, der gegebenenfalls - neben der bereits vorhandenen Doppelbindung - eine - oder im Falle eines 6- oder 7-gliedrigen Rings - zwei weitere Doppelbindungen aufweisen kann und gegebenenfalls mit Alkyl- oder Arylgruppen und/oder mit Gruppen mit Donor- oder Akzeptorwirkung substituiert sein kann und gegebenenfalls mindestens ein Heteroatom enthalten kann, und der 5- bis 7-gliedrige Ring gegebenenfalls mit einem oder mehreren weiteren Ringen anelliert sein kann;
weiterhin können Y¹ und R¹ über eine Brücke miteinander verknüpft sein, wobei die Brücke die folgenden Bedeutungen aufweisen kann:
   Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
   x 2 bis 10; und
   R¹⁸, R¹⁹, R²⁰, R²¹, R²², R³⁰, R³¹
      H, Alkyl, Aryl, Heteroaryl, Alkenyl, Alkinyl
   bedeuten;
   R³ Wasserstoff, ein Alkyl-, Aryl-, Heteroaryl-, Alkinyl- oder Alkenylrest;
   Y³ Wasserstoff, ein Alkyl-, Alkinyl- oder Alkenylrest,
   oder 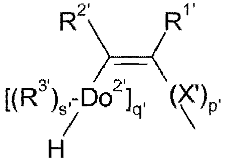 wobei Do²', q', s', R³', R¹', R²', X' und p' unabhängig die gleichen Bedeutungen wie Do², q, s, R³, R¹, R², X und p aufweisen;
weiterhin können Y² und Y³ in jedem der n Carbenliganden über eine Brücke miteinander verknüpft sein, wobei die Brücke die folgenden Bedeutungen aufweisen kann:
   Alkylen, Arylen, Heteroarylen, Alkinylen, Alkenylen, NR²⁵, PR²⁶, BR²⁷, O, S, SO SO₂, SiR³² R³³, CO, CO-O, O-CO und (CR²⁸R²⁹)_{y}, wobei eine oder mehrere nicht benachbarte Gruppen (CR²⁸R²⁹) durch NR²⁵, PR²⁶, BR²⁷, O, S, SO, SO₂, SiR³²R³³, CO, CO-O, O-CO ersetzt sein können, wobei
   y 2 bis 10;
      und
   R²⁵, R²⁶, R²⁷, R²⁸, R²⁹, R³², R³³
      H, Alkyl, Aryl, Heteroaryl, Alkinyl, Alkenyl bedeuten.

Die Begriffe Arylrest oder -gruppe, Heteroarylrest oder -gruppe, Alkylrest oder -gruppe, Alkenylrest oder -gruppe und Alkinylrest oder -gruppe sowie Gruppen oder Substituenten mit Donor- oder Akzeptorwirkung haben die in der europäischen Anmeldung mit dem Aktenzeichen 06112198.4 aufgeführten Bedeutungen.

Bevorzugt haben die Begriffe Arylrest oder -gruppe, Heteroarylrest oder -gruppe, Alkylrest oder -gruppe sowie Gruppen oder Substituenten mit Donor- oder Akzeptorwirkung die nachstehend genannten Bedeutungen:
Die Alkylreste sowie die Alkylreste der Alkoxygruppen gemäß der vorliegenden Anmeldung können sowohl geradkettig als auch verzweigt oder cyclisch und/oder optional substituiert sein mit Substituenten ausgewählt aus der Gruppe bestehend aus Aryl, Alkoxy und Halogen. Geeignete Arylsubstituenten sind nachstehend genannt. Beispiele für geeignete Alkylgruppen sind C₁-C₂₀-Alkyl, bevorzugt C₁-C₁₀-Alkyl, besonders bevorzugt Methyl, Ethyl, Propyl, Butyl, Pentyl, Hexyl, Heptyl und Octyl sowie mit Aryl-, Alkoxy- und/oder Halogen, insbesondere F, substituierte Derivate der genannten Alkylgruppen wie CF₃. Dabei sind sowohl die n-Isomere dieser Reste als auch verzweigte Isomere wie Isopropyl, Isobutyl, Isopentyl, sec-Butyl, tert-Butyl, Neopentyl, 3,3-Dimethylbutyl, 2-Ethylhexyl usw. mit umfasst. Bevorzugte Alkylgruppen sind Methyl, Ethyl, tert-Butyl und CF₃.

Die cyclischen Alkylreste gemäß der vorliegenden Anmeldung können optional substituiert sein mit Substituenten ausgewählt aus der Gruppe bestehend aus Aryl, Alkoxy und Halogen. Bevorzugt sind die cyclischen Alkylreste unsubstituiert. Geeignete Arylsubstituenten sind nachstehend genannt. Beispiele für geeignete cyclische Alkylreste sind C₃- bis C₂₀-Cycloalkyl, bevorzugt C₃- bis C₁₀-Cycloalkyl, besonders bevorzugt sind Cyclopropyl, Cyclobutyl, Cyclopentyl, Cyclohexyl, Cycloheptyl, Cyclooctyl, Cyclononyl und Cyclodecyl. Gegebenenfalls kann es sich auch um polycyclische Ringsysteme handeln, wie Decalinyl, Norbornanyl, Bornanyl oder Adamantyl. Die cyclischen Alkylreste können unsubstituiert oder gegebenenfalls mit einem oder mehreren weiteren Resten, insbesondere Alkyl, Aryl, Alkoxy und/oder Halogen, substituiert sein.

Geeignete Halogensubstituenten im Sinne der vorliegenden Anmeldung sind Fluor, Chlor, Brom und Jod, bevorzugt Fluor, Chlor und Brom, besonders bevorzugt Fluor und Chlor.

Geeignete Alkoxy- und Alkylthiogruppen leiten sich entsprechend von den Alkylresten ab, wie sie vorstehend definiert wurden. Beispielsweise sind hier zu nennen OCH₃, OC₂H₅, OC₃H₇, OC₄H₉ und OCₐH₁₇ sowie SCH₃, SC₂H₅, SC₃H₇, SC₄H₉ und SC₈H₁₇. Dabei sind unter C₃H₇, C₄H₉ und C₈H₁₇ sowohl die n-Isomere als auch verzweigte Isomere wie isoPropyl, iso-Butyl, sec-Butyl, tert-Butyl und 2-Ethylhexyl umfasst. Besonders bevorzugt sind Methoxy, Ethoxy, n-Octyloxy, 2-Ethylhexyloxy und SCH₃.

Als Aryl werden in der vorliegenden Erfindung Reste bezeichnet, die von monocyclischen, bicyclischen oder tricyclischen Aromaten abgeleitet sind, die keine Ringheteroatome enthalten. Sofern es sich nicht um monocyclische Systeme handelt, ist bei der Bezeichnung Aryl für den zweiten Ring auch die gesättigte Form (Perhydroform) oder die teilweise ungesättigte Form (beispielsweise die Dihydroform oder Tetrahydroform), sofern die jeweiligen Formen bekannt und stabil sind, möglich. Das heißt, die Bezeichnung Aryl umfasst in der vorliegenden Erfindung beispielsweise auch bicyclische oder tricyclische Reste, in denen sowohl beide oder alle drei Reste aromatisch sind als auch bicyclische oder tricyclische Reste, in denen nur ein Ring aromatisch ist, sowie tricyclische Reste, worin zwei Ringe aromatisch sind. Beispiele für Aryl sind: C₆-C₃₀-Aryl, bevorzugt C₆-C₁₈-Aryl, wobei sich die Zahl der Kohlenstoffatome auf das Aryl-Grundgerüst bezieht, besonders bevorzugt Phenyl, Naphthyl, Indanyl, 1,2-Dihydronaphthenyl, 1,4-Dihydronaphthenyl, Indenyl, Anthracenyl, Phenanthrenyl oder 1,2,3,4-Tetrahydronaphthyl. Besonders bevorzugt ist Aryl Phenyl oder Naphthyl, ganz besonders bevorzugt Phenyl.

Die Arylreste können unsubstituiert sein oder mit einem mehreren weiteren Resten substituiert sein. Geeignete weitere Reste sind ausgewählt aus der Gruppe bestehend aus C₁-C₂₀-Alkyl, C₆-C₃₀-Aryl oder Substituenten mit Donor- oder Akzeptorwirkung, wobei geeignete Substituenten mit Donor- oder Akzeptorwirkung nachstehend genannt sind. Bevorzugt sind die Arylreste unsubstituiert oder mit einer oder mehreren C₁-C₂₀-Alkoxygruppen, CN, CF₃, F oder Aminogruppen (NR^{'}R^{"}, wobei geeignete Reste R^{'} und R^{"} Alkyl oder Aryl bedeuten), substituiert. Weitere bevorzugte Substitutionen der Arylreste in den Verbindungen der nachstehend genannten Verbindungen der Formel (III) sind abhängig von dem Einsatzzweck der Verbindungen der Formel (III) und sind nachstehend genannt.

Geeignete Aryloxy-, Arylthio- und Arylcarbonyloxygruppen leiten sich entsprechend von den Arylresten ab, wie sie vorstehend definiert wurden. Besonders bevorzugt ist Phenoxy, Phenylthio und Phenylcarbonyloxy.

Geeignete Aminogruppen weisen die allgemeine Formel -NR'R^{"} auf, wobei R^{'} und R^{"} unabhängig voneinander Alkyl oder Aryl bedeuten. Geeignete Alkyl und Arylreste, die jeweils gegebenenfalls substituiert sein können, sind vorstehend genannt. Beispiele für geeignete Aminogruppen sind Diarylaminogruppen wie Diphenylamino und Dialkylaminogruppen wie Dimethylamino, Diethylamino und Arylalkylaminogruppen wie Phenylmethylamino.

Unter Heteroaryl ist unsubstituiertes oder substituiertes Heteroaryl mit 5 bis 30 Ringatomen zu verstehen, wobei es sich bevorzugt um monocyclische, bicyclische oder tricyclische Heteroaromaten handelt, die sich zum Teil vom vorstehend genannten Aryl ableiten lassen, in dem im Aryl-Grundgerüst mindestens ein Kohlenstoffatom durch ein Heteroatom ersetzt ist. Bevorzugte Heteroatome sind N, O und S. Besonders bevorzugt weisen die Heteroarylreste 5 bis 13 Ringatome auf. Insbesondere bevorzugt ist das Grundgerüst der Heteroarylreste ausgewählt aus Systemen wie Pyridin und fünfgliedrigen Heteroaromaten wie Thiophen, Pyrrol, Imidazol oder Furan. Diese Grundgerüste können gegebenenfalls mit einem oder zwei sechsgliedrigen aromatischen Resten anelliert sein. Geeignete anellierte Heteroaromaten sind Carbazolyl, Benzimidazolyl, Benzofuryl, Dibenzofuryl oder Dibenzothiophenyl. Das Grundgerüst kann an einer, mehreren oder allen substituierbaren Positionen substituiert sein, wobei geeignete Substituenten dieselben sind, die bereits unter der Definition von C₆-C₃₀-Aryl genannt wurden. Bevorzugt sind die Heteroarylreste jedoch unsubstituiert. Geeignete Heteroarylreste sind zum Beispiel Pyridin-2-yl, Pyridin-3-yl, Pyridin-4-yl, Thiophen-2-yl, Thiophen-3-yl, Pyrrol-2-yl, Pyrrol-3-yl, Furan-2-yl, Furan-3-yl und Imidazol-2-yl sowie die entsprechenden benzanellierten Reste, insbesondere Carbazolyl, Benzimidazolyl, Benzofuryl, Dibenzofuryl oder Dibenzothiophenyl.

Unter heterocyclischem Alkyl sind Reste zu verstehen, die sich vom vorstehend genannten cyclischen Alkyl dadurch unterscheiden, dass im cyclischen Alkyl-Grundgerüst mindestens ein Kohlenstoffatom durch ein Heteroatom ersetzt ist. Bevorzugte Heteroatome sind N, O und S. Das Grundgerüst kann an einer, mehreren oder allen substituierbaren Positionen substituiert sein, wobei geeignete Substituenten dieselben sind, die bereits unter der Definition von Aryl genannt wurden. Insbesondere sind hier die stickstoffhaltigen Reste Pyrrolidin-2-yl, Pyrrolidin-3-yl, Piperidin-2-yl, Piperidin-3-yl, Piperidin-4-yl zu nennen.

Unter Gruppen mit Donor- oder Akzeptorwirkung sind im Sinne der vorliegenden Anmeldung die folgenden Gruppen zu verstehen:
Unter Gruppen mit Donorwirkung sind Gruppen zu verstehen, die einen +I- und/oder +M-Effekt aufweisen, und unter Gruppen mit Akzeptorwirkung sind Gruppen zu verstehend, die einen -I- und/oder -M-Effekt aufweisen. Bevorzugte Gruppen mit Donor- oder Akzeptorwirkung sind nachstehend genannt:
C₁-C₂₀-Alkoxy, C₆-C₃₀-Aryloxy, C₁-C₂₀-Alkylthio, C₆-C₃₀-Arylthio, SiR³⁴R³⁵R³⁶, Halogenresten, halogenierten C₁-C₂₀-Alkylresten, Carbonyl (-CO(R³⁴)), Carbonylthio (- C = O (SR³⁴)), Carbonyloxy (- C = O(OR³⁴)), Oxycarbonyl (- OC = O(R³⁴)), Thiocarbonyl (- SC = O(R³⁴)), Amino (-NR³⁴R³⁵), OH, Pseudohalogenresten, Amido (- C = O (NR³⁴)), -NR³⁴C = O (R³⁵), Phosphonat (- P(O) (OR³⁴)₂, Phosphat (-OP(O) (OR³⁴)₂), Phosphin (-PR³⁴R³⁵), Phosphinoxid (-P(O)R³⁴₂), Sulfat (-OS(O)₂OR³⁴), Sulfoxid (-S(O)R³⁴), Sulfonat (-S(O)₂OR³⁴), Sulfonyl (-S(O)₂R³⁴), Sulfonamid (-S(O)₂NR³⁴R³⁵), NO₂, Boronsäureestern (-OB(OR³⁴)₂), Imino (-C = NR³⁴R³⁵)), Boranresten, Stannanresten, Hydrazinresten, Hydrazonresten, Oximresten, Nitroso-Gruppen, Diazo-Gruppen, Vinylgruppen, Sulfoximine, Alane, Germane, Boroxime und Borazine.

Bevorzugte Substituenten mit Donor- oder Akzeptorwirkung sind ausgewählt aus der Gruppe bestehend aus:
C₁- bis C₂₀-Alkoxy, bevorzugt C₁-C₆-Alkoxy, besonders bevorzugt Ethoxy oder Methoxy; C₆-C₃₀-Aryloxy, bevorzugt C₆-C₁₀-Aryloxy, besonders bevorzugt Phenyloxy; SiR³⁴R³⁵R³⁶, wobei R³⁴, R³⁵ und R³⁶ bevorzugt unabhängig voneinander substituiertes oder unsubstituiertes Alkyl oder substituiertes oder unsubstituiertes Phenyl bedeuten; besonders bevorzugt ist mindenstens einer der Reste R³⁴,R³⁵ oder R³⁶ substituiertes oder unsubstituiertes Phenyl, ganz besonders bevorzugt ist mindenstens einer der Reste R³⁴,R³⁵ und R³⁶ substituiertes Phenyl, wobei geeignete Substituenten vorstehend genannt sind; Halogenresten, bevorzugt F, Cl, Br, besonders bevorzugt F oder Cl, ganz besonders bevorzugt F, halogenierten C₁-C₂₀-Alkylresten, bevorzugt halogenierten C₁-C₆-Alkylresten, ganz besonders bevorzugt fluorierten C₁-C₆-Alkylresten, z. B. CF₃, CH₂F, CHF₂ oder C₂F₅; Amino, bevorzugt Dimethylamino, Diethylamino oder Diphenylamino; OH, Pseudohalogenresten, bevorzugt CN, SCN oder OCN, besonders bevorzugt CN, -C(O)OC₁-C₄-Alkyl, bevorzugt - C(O)OMe, P(O)R₂, bevorzugt P(O)Ph₂ oder SO₂R₂, bevorzugt SO₂Ph.

Ganz besonders bevorzugte Substituenten mit Donor- oder Akzeptorwirkung sind ausgewählt aus der Gruppe bestehend aus Methoxy, Phenyloxy, halogeniertem C₁-C₄-Alkyl, bevorzugt CF₃, CH₂F, CHF₂, C₂F₅, Halogen, bevorzugt F, CN, SiR³⁴R³⁵R³⁶, wobei geeignete Reste R³⁴, R³⁵ und R³⁶ bereits genannt sind, Diphenylamino, -C(O)OC₁-C₄-Alkyl, bevorzugt -C(O)OMe, P(O)Ph₂, SO₂Ph.

Durch die vorstehend genannten Gruppen mit Donor- oder Akzeptorwirkung soll nicht ausgeschlossen werden, dass auch weitere der vorstehend genannten Reste und Gruppen eine Donor- oder Akzeptorwirkung aufweisen können. Beispielsweise handelt es sich bei den vorstehend genannten Heteroarylresten ebenfalls um Gruppen mit Donor- oder Akzeptorwirkung und bei den C₁-C₂₀-Alkylresten handelt es sich um Gruppen mit Donorwirkung.

Die in den vorstehend genannten Gruppen mit Donor- oder Akzeptorwirkung erwähnten Reste R³⁴, R³⁵ und R³⁶ haben die bereits vorstehend erwähnten Bedeutungen, d. h. R³⁴, R³⁵, R³⁶ bedeuten unabhängig voneinander:
Substituiertes oder unsubstituiertes C₁-C₂₀-Alkyl oder substituiertes oder unsubstituiertes C₆-C₃₀-Aryl, wobei geeignete und bevorzugte Alkyl- und Arylreste vorstehend genannt sind. Besonders bevorzugt bedeuten die Reste R³⁴, R³⁵ und R¹⁶ C₁-C₆-Alkyl, z. B. Methyl, Ethyl oder i-Propyl, Phenyl oder Benzyl. In einer bevorzugten Ausführungsform - im Falle von SiR³⁴R³⁵R³⁶ - bedeuten R³⁴,R³⁵ und R³⁶ bevorzugt unabhängig voneinander substituiertes oder unsubstituiertes C₁-C₂₀-Alkyl oder substituiertes oder unsubstituiertes Phenyl; besonders bevorzugt ist mindenstens einer der Reste R³⁴,R³⁵ oder R³⁶ substituiertes oder unsubstituiertes Phenyl, ganz besonders bevorzugt ist mindenstens einer der Reste R³⁴,R³⁵ und R³⁶ substituiertes Phenyl, wobei geeignete Substituenten vorstehend genannt sind. Bevorzugte Carbenliganden der Formel II sind ebenfalls die in der europäischen Anmeldung mit dem Aktenzeichen 06112198.4 offenbarten Carbenliganden. Besonders bevorzugte Carbenliganden weisen die folgenden allgemeinen Formeln aa bis ae auf: 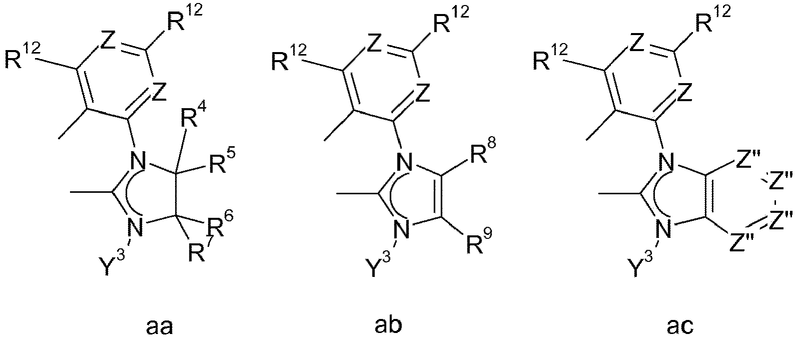 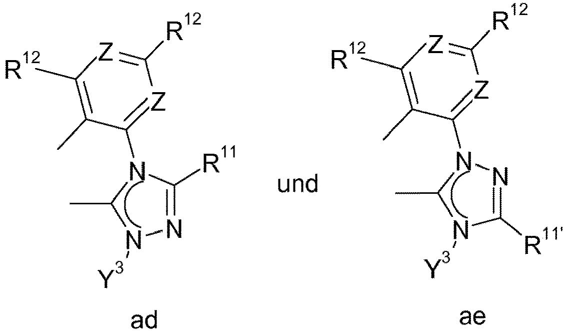 worin die Symbole die folgenden Bedeutungen aufweisen:
- Y³: ein Alkyl-, Alkinyl- oder Alkenylrest
oder eine Gruppe der folgenden Struktur: 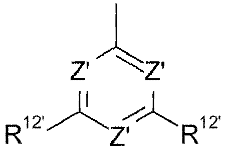
- Z: gleich oder verschieden CR¹² oder N;
- Z': gleich oder verschieden CR^{12,} oder N;
- Z": gleich oder verschieden CR¹⁰ oder N;
- R¹², R^{12,}: gleich oder verschieden jeweils unabhängig voneinander H, ein Alkyl-, Aryl-, Heteroaryl-, Alkinyl- oder Alkenylrest, oder jeweils zwei Reste R¹² bzw. R^{12,} bilden gemeinsam einen anellierten Ring, der gegebenenfalls mindestens ein Heteroatom enthalten kann, oder R¹² bzw. R^{12,} bedeutet ein Rest mit Donor- oder Akzeptorwirkung;
- R⁴, R⁵, R⁶, R⁷, R⁸, R⁹, R¹¹ und R^{11,}: Wasserstoff, Alkyl, Aryl, Heteroaryl, Alkinyl oder Alkenyl oder ein Rest mit Donor- oder Akzeptorwirkung;
- R¹⁰: in den Gruppen Z" unabhängig voneinander H, Alkyl, Aryl, Heteroaryl, Alkinyl oder Alkenyl oder jeweils zwei Reste R¹⁰ bilden gemeinsam einen anellierten Ring, der gegebenenfalls mindestens ein Heteroatom enthalten kann, oder R¹⁰ bedeutet einen Rest mit Donor- oder Akzeptorwirkung;
weiterhin kann die Gruppe der Struktur 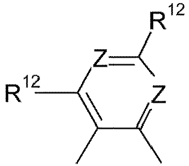 über den aromatischen Grundkörper oder über einen der Reste R¹² mit R⁴ oder R⁵ oder dem Kohlenstoffatom, mit dem R⁴ und R⁵ verknüpft sind, in der Gruppierung aa, R⁸ oder dem Kohlenstoffatom mit dem R⁸ verknüpft ist, in der Gruppierung ab, einem der Reste R¹⁰ oder einem der Kohlenstoffatome, mit dem R¹⁰ verknüpft ist, in der Gruppierung ac und R¹¹ oder dem Kohlenstoffatom, mit dem R¹¹ verknüpft ist, in der Gruppierung ad über eine Brücke verknüpft sein;
und/oder
die Gruppe der Struktur 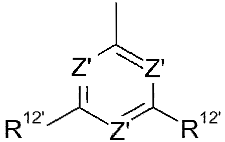 über den aromatischen Grundkörper oder über einen der Reste R^{12,} mit R⁶ oder R⁷ oder dem Kohlenstoffatom, mit dem R⁶ oder R⁷ verknüpft sind, in der Gruppierung aa, R⁹ oder dem Kohlenstoffatom, mit dem R⁹ verknüpft ist, in der Gruppierung ab, einem der Reste R¹⁰ oder einem der Kohlenstoffatome, mit dem R¹⁰ verknüpft ist, in der Gruppierung ac und R¹¹ oder dem Kohlenstoffatom, mit dem R^{11,} verknüpft ist, in der Gruppierung ae über eine Brücke verknüpft sein;
wobei die jeweilige Brücke die folgenden Bedeutungen aufweisen kann:
Alkylen, Arlyen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
   und
R¹⁸, R¹⁹, R²⁰, R²¹, R²², R³⁰, R³¹
   H, Alkyl, Aryl, Heteroaryl, Alkinyl, Alkenyl
bedeuten;
wobei in den Fällen, worin die Gruppe der Struktur 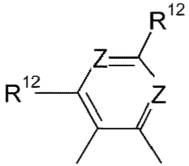 über eine Brücke mit dem Kohlenstoffatom, mit dem R⁴ und R⁵ verknüpft sind (Gruppierung aa), dem Kohlenstoffatom, mit dem R⁸ verknüpft ist (Gruppierung ab), einem der Kohlenstoffatome, mit dem R¹⁰ verknüpft ist (Gruppierung ac) oder dem Kohlenstoffatom, mit dem R¹¹ verknüpft ist (Gruppierung ad), verknüpft ist, der jeweilige Rest R⁴ oder R⁵, R⁸, einer der Reste R¹⁰ oder R¹¹ durch eine Bindung zu der Brücke ersetzt ist;
und in den Fällen, worin die Gruppe der Struktur 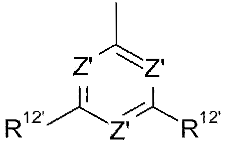 über eine Brücke mit dem Kohlenstoffatom, mit dem R⁶ und R⁷ verknüpft sind (Gruppierung aa), dem Kohlenstoffatom, mit dem R⁹ verknüpft ist (Gruppierung ab), einem der Kohlenstoffatome, mit dem R¹⁰ verknüpft ist (Gruppierung ac) oder dem Kohlenstoffatom, mit dem R¹¹ verknüpft ist (Gruppierung ad), verknüpft ist, der jeweilige Rest R⁶ oder R⁷, R⁹, einer der Reste R¹⁰ oder R^{11,} durch eine Bindung zu der Brücke ersetzt ist.

Der Carbenligand kann entweder "symmetrisch" oder "unsymmetrisch" sein. Dabei ist unter einem "symmetrischen" Carbenliganden ein Carbenligand zu verstehen, worin Y³ eine Gruppe der folgenden Struktur 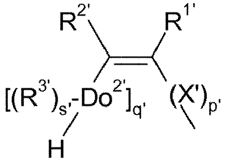 ist, wobei die Symbole Z' und R^{12,} die vorstehend genannten Bedeutungen aufweisen;
unter einem "unsymmetrischen" Carbenliganden ist ein Carbenligand zu verstehen, worin Y³ Wasserstoff, ein Alkyl-, ein Alkinyl- oder ein Alkenylrest, bevorzugt ein Alkyl-, Alkinyl- oder Alkenylrest ist, wobei sowohl bevorzugte Alkyl-, Alkinyl- oder Alkenylreste als auch bevorzugte Gruppen der Formel 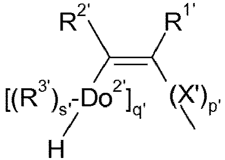 z. B. in der europäischen Anmeldung mit dem Aktenzeichen 06112198.4 genannt sind.

Bevorzugte "symmetrische" Carbenkomplexe sind z. B. in WO 05/019373 offenbart.

Besonders bevorzugte "symmetrische" Carbenkomplexe sind Ir-Carbenkomplexe der allgemeinen Formeln la bis Id 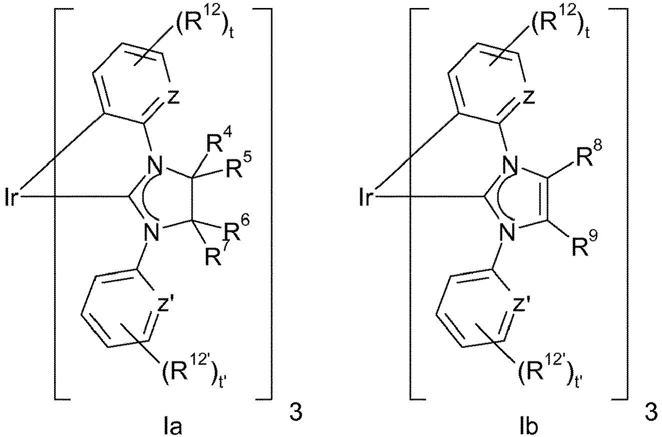 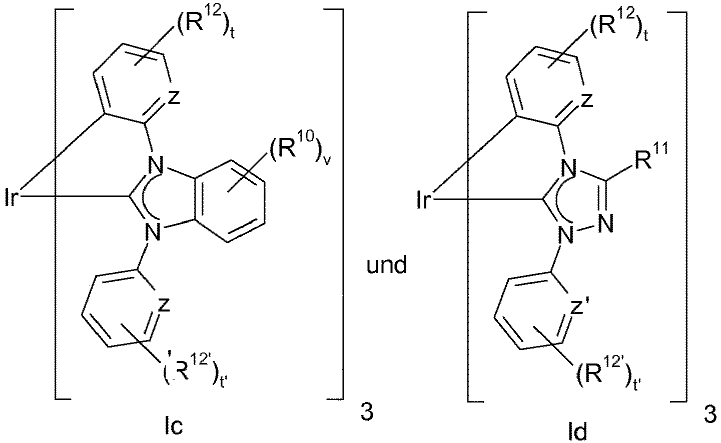 worin R⁴, R⁵, R⁶, R⁷, R⁸, R⁹, R¹⁰ und R¹² und R^{12,} die vorstehend genannten Bedeutungen aufweisen,
- Z, Z': gleich oder verschieden, CH oder N bedeuten;
- t und t': gleich oder verschieden, bevorzugt gleich, 0 bis 3, wobei, wenn t bzw. t' > 1 ist, die Reste R¹² bzw. R^{12,} gleich oder verschieden sein können, bevorzugt ist t bzw. t' 0 oder 1, der Rest R¹² bzw. R^{12,} befindet sich, wenn t bzw. t' 1 ist, in ortho-, meta- oder para-Position zur Verknüpfungsstelle mit dem dem Carbenkohlenstoffatom benachbarten Stickstoffatom; und
- v: 0 bis 4, bevorzugt 0,1 oder 2, ganz besonders bevorzugt 0, wobei, wenn v 0 ist, die vier Kohlenstoffatome des Arylrests in Formel Ic, die gegebenenfalls mit R¹⁰ substituiert sind, Wasserstoffatome tragen.

Besonders bevorzugt sind "symmetrische" Carbenkomplexe der Formel Ia bis Id, worin Z und Z' CH, R⁸ und R⁹ H, t, t' und v 0 bedeuten und die übrigen Reste die bereits vorstehend genannten Bedeutungen aufweisen.

Ganz besonders bevorzugte "symmetrische" Carbenkomplexe sind Carbenkomplexe der Formeln Ib und Ic, wobei R⁸ und R⁹ in den Carbenkomplexen der Formel Ib ganz besonders bevorzugt H bedeuten und t und t' in den Carbenkomplexen der Formeln Ib und Ic unabhängig voneinander 0 oder 1 bedeuten, wobei R¹² und R^{12,} besonders bevorzugt ein Alkylrest oder eine Gruppe mit Donor- oder Akzeptorwirkung, z. B. ausgewählt aus der Gruppe bestehend aus F, Alkoxy-, Aryloxy-, Carbonyl-, Ester-, Aminogruppen, Amidresten, CHF₂, CH₂F, CF₃, CN, Thiogruppen und SCN bedeutet, und v in den Carbenkomplexen der Formel Ic besonders bevorzugt 0 ist.

Bevorzugte "unsymmetrische" Carbenkomplexe sind in WO 06/056418 offenbart.

Besonders bevorzugte "unsymmetrische" Carbenkomplexe sind Ir-Carbenkomplexe, die die allgemeinen Formeln le bis Ii aufweisen. 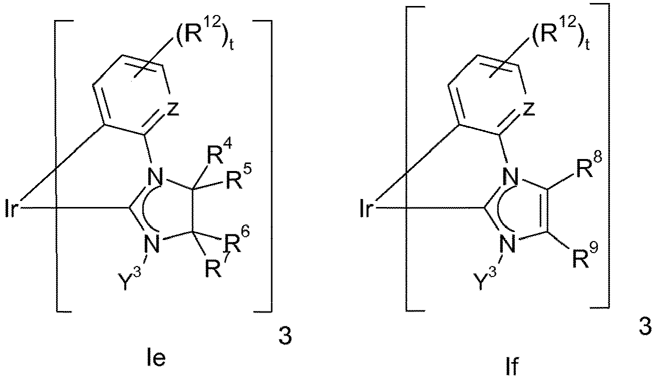 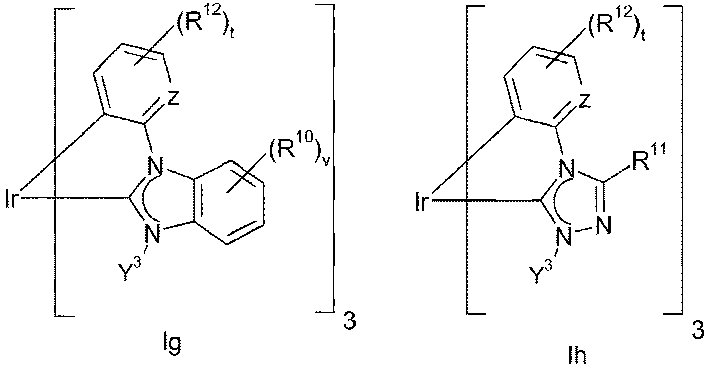 und 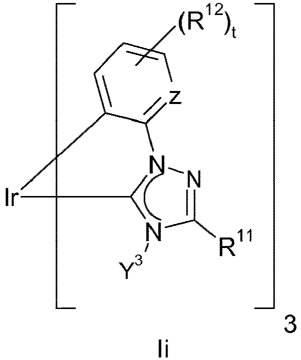 worin R⁴, R⁵, R⁶, R⁷, R⁸, R⁹, R^{11,} R^{11,}, R¹², Z und Z" die vorstehend bezüglich der "symmetrischen" Carbenkomplexe genannten Bedeutungen aufweisen; und
- Y³: Wasserstoff, ein Alkyl-, Aryl-, Heteroaryl-, Alkinyl- oder Alkenylrest, bevorzugt ein Alkyl-, Heteroaryl- oder Arylrest, besonders bevorzugt ein Alkylrest ist.

Ganz besonders bevorzugt sind "unsymmetrische" Carbenkomplexe der Formeln If und Ig.

Ganz besonders bevorzugt sind "unsymmetrische" Carbenkomplexe, worin Z CR¹², Z" CH und Y³ Alkyl bedeuten, wobei R¹² besonders bevorzugt Wasserstoff, Alkyl oder ein Rest mit Donor- oder Akzeptorwirkung, z.B. ausgewählt aus der Gruppe bestehend aus F, Alkoxy-, Aryloxy-, Carbonyl, Ester-, Aminogruppen, Amidresten, CHF₂, CH₂F, CF₃, CN, Thiogruppen und SCN, bedeuten, wobei bevorzugt drei der vier möglichen Substituenten R¹² Wasserstoff bedeuten und einer der Reste R¹² Wasserstoff, Alkyl oder ein Rest mit Donor- oder Akzeptorwirkung bedeutet.

Neben den vorstehend dargestellten homoleptischen Carbenkomplexen, d.h. Carbenkomplexen, die identische Carbenliganden tragen, sind auch heteroleptische Carbenkomplexe, wie sie z.B. in der Europäischen Anmeldung mit dem Aktenzeichen 06112228.9 offenbart sind, geeignet. Des Weiteren sind Carbenkomplexe geeignet, die neben Carbenliganden weitere Nicht-Carbenliganden tragen. Geeignete Komplexe, die neben Carbenliganden Nicht-Carbenliganden tragen, sind z.B. in der Europäischen Anmeldung mit dem Aktenzeichen 06112198.4 offenbart. Des Weiteren können in den erfindungsgemäßen OLEDs spezielle Übergangsmetallcarbenkomplexe, wie sie in den Europäischen Anmeldungen mit den Aktenzeichen 06112198.4 und 06116100.6 offenbart sind, eingesetzt werden.

Die Herstellung der bevorzugt in den erfindungsgemäßen OLEDs eingesetzten Carbenkomplexe kann gemäß dem Fachmann bekannten Verfahren erfolgen. Geeignete Herstellungsverfahren sind z. B. in WO 05/019373, WO 06/056418, in den Europäischen Anmeldungen mit den Aktenzeichen 06101109.4, 06112198.4, 06112228.9, 06116100.6 und 06116093.3 und der darin zitierten Literatur offenbart.

Bevorzugt ist der in der erfindungsgemäßen OLED in der Licht-emittierenden Schicht C eingesetzte Phosphoreszenz-Emitter CB ein Carbenkomplex, besonders bevorzugt ein Carbenkomplex, wie er vorstehend definiert wurde.

In der vorliegenden Erfindung ist das mindestens eine Loch-leitende Material der Loch-leitenden Schicht B und das mindestens eine Loch-leitende Material CA der Licht-emittierenden Schicht C ein Carbenkomplex, bevorzugt ein Carbenkomplex wie er vorstehend definiert ist. Dabei können die Carbenkomplexe der Loch-leitenden Materialien in den Schichten B und C gleich oder verschieden sein.

In einer besonders bevorzugten Ausführungsform sind der in der Licht-emittierenden Schicht C eingesetzte Phosphoreszenz-Emitter CB sowie das mindestens eine Loch-leitende Material CA in der Licht-emittierenden Schicht C und das mindestens eine Loch-leitende Material der Loch-leitenden Schicht B jeweils ein Carbenkomplex. Dabei sind die Carbenkomplexe des Loch-leitenden Materials in der Loch-leitenden Schicht B und in der Licht-emittierenden Schicht C von dem Carbenkomplex des Phosphoreszenz-Emitters CB in der Licht-emittierenden Schicht C verschieden, wobei die Bandlücke der als Loch-leitendes Material eingesetzten Carbenkomplexe größer ist als die Bandlücke des Carbenkomplexes, der als Phosphoreszenz-Emitter eingesetzt wird.

### Elektronen-leitende Schicht D

Geeignete Materialien für die Elektronen-leitende Schicht (auch Elektronentransportschicht genannt) sind dem Fachmann bekannt. Beispiele für eine geeignete Elektronen-leitende Schicht ist eine Elektronen-leitende Schicht auf Basis von Aluminium-tris-8-hydroxy-chinolinat (AlQ₃) oder 1,3,5-tris(N-Phenyl-2-benzylimidazol)-benzol) (TPBI).

### Kathode E

Geeignete Kathodenmaterialien sind üblicherweise Metalle, Metallkombinationen oder Metallegierungen mit niedriger Austrittsarbeit. Beispiele sind Ca, Ba, Cs, Mg, Al, In und Mg/Ag. Geeignete Kathodenmaterialien sind dem Fachmann bekannt.

### OLED-Aufbau

Die erfindungsgemäße OLED
weist zwischen der Licht-emittierenden Schicht C und der Elektronen-leitenden Schicht D in direktem Kontakt zu der Licht-emittierenden Schicht C eine Loch-blockierende Schicht, aufgebaut aus mindestens einem Lochblockermaterial und/oder Excitonenblockermaterial, wobei das Lochblockermaterial gleichzeitig als Excitonenblockermaterial dienen kann, auf.

In einer weiteren Ausführungsform weist die organische Leuchtdiode zwischen der Loch-leitenden Schicht B und der Licht-emittierenden Schicht C eine Elektronen-blockierende Schicht, aufgebaut aus mindestens einem Elektronenblockermaterial und/oder Excitonenblockermaterial auf.

Des Weiteren kann die erfindungsgemäße organische Leuchtdiode zusätzlich zu den Schichten A bis E und der Loch-blockierenden Schicht weitere Schichten enthalten, z. B. eine Lochinjektionsschicht zwischen der Anode A und der Loch-leitenden Schicht B, wobei geeignete Materialien für die Lochinjektionsschicht dem Fachmann bekannt sind. Beispiele für geeignete Materialien sind Materialien auf Basis von Kupferphthalocyanin (CuPc) oder leitfähigen Polymeren wie Polyanilin (PANI) oder Polythiophen-Derivaten wie PEDOT. Des Weiteren kann die erfindungsgemäße OLED eine oder mehrere Elektroneninjektionsschichten, die zwischen der Elektronen-leitenden-Schicht und der Kathode angeordnet ist/sind, enthalten, wobei diese Schicht teilweise mit einer der anderen Schichten zusammenfallen kann, bzw. aus einem Teil der Kathode gebildet sein kann. Üblicherweise sind die Elektroneninjektionsschichten dünne Schichten aufgebaut aus einem Material mit einer hohen Dielektrizitätskonstante, z. B. LiF, Li₂O, BaF₂, MgO und/oder NaF.

Die erfindungsgemäße organische Leuchtdiode weist
in der Loch-blockierenden Schicht
mindestens eine Verbindung ausgewählt aus Disilylcarbazolen, Disilyldibenzofuranen, Disilyldibenzothiophenen, Disilyldibenzophospholen, Disilyldibenzothiophen-S-oxiden und Disilyldibenzothiophen-S,S-dioxiden der allgemeinen Formel III auf 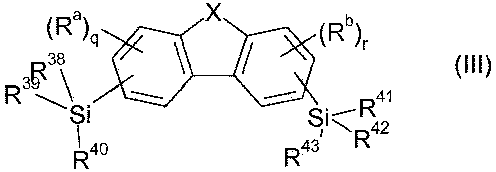 worin bedeuten:
- X: NR³⁷, S, O, PR³⁷, SO₂ oder SO;
- R³⁷: substituiertes oder unsubstituiertes C₁-C₂₀-Alkyl, substituiertes oder unsubstituiertes C₆-C₃₀-Aryl oder substituiertes oder unsubstituiertes Heteroaryl mit 5 bis 30 Ringatomen;
- R³⁸, R³⁸, R⁴⁰, R⁴¹, R⁴², R⁴³: unabhängig voneinander substiuiertes oder unsubstituiertes C₁-C₂₀-Alkyl oder substituiertes oder unsubstituiertes C₆-C₃₀-Aryl oder eine Struktur der allgemeinen Formel (c) 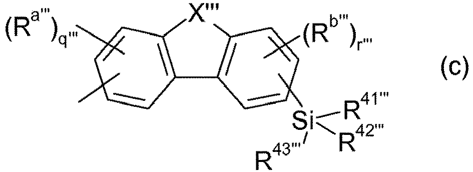
- R^{a}, R^{b}: unabhängig voneinander substituiertes oder unsubstituiertes C₁-C₂₀-Alkyl, substituiertes oder unsubstituiertes C₆-C₃₀-Aryl, substituiertes oder unsubstituiertes Heteroaryl mit 5 bis 30 Ringatomen oder ein Substituent mit Donor- oder Akzeptorwirkung ausgewählt aus der Gruppe bestehend aus: C₁-C₂₀-Alkoxy, C₆-C₃₀-Aryloxy, C₁-C₂₀-Alkylthio, C₆-C₃₀-Arylthio, SiR³⁴R³⁵R³⁶, Halogenresten, halogenierten C₁-C₂₀-Alkylresten, Carbonyl (-CO(R³⁴)), Carbonylthio (- C = O (SR³⁴)), Carbonyloxy (- C = O(OR³⁴)), Oxycarbonyl (- OC = O(R³⁴)), Thiocarbonyl (- SC = O(R³⁴)), Amino (-NR³⁴R³⁵), OH, Pseudohalogenresten, Amido (- C = O (NR³⁴)), -NR³⁴C = O (R³⁵), Phosphonat (- P(O) (OR³⁴)₂, Phosphat (-OP(O) (OR³⁴)₂), Phosphin (-PR³⁴R³⁵), Phosphinoxid (-P(O)R³⁴₂), Sulfat (-OS(O)₂OR³⁴), Sulfoxid (-S(O)R³⁴), Sulfonat (-S(O)₂OR³⁴), Sulfonyl (-S(O)₂R³⁴), Sulfonamid (-S(O)₂NR³⁴R³⁵), NO₂, Boronsäureestern (-OB(OR³⁴)₂), Imino (-C = NR³⁴R³⁵)), Boranresten, Stannanresten, Hydrazinresten, Hydrazonresten, Oximresten, Nitroso-Gruppen, Diazo-Gruppen, Vinylgruppen, Sulfoximinen, Alanen, Germanen, Boroximen und Borazinen;
- R³⁴, R³⁵, R³⁶: unabhängig voneinander substituiertes oder unsubstituiertes C₁-C₂₀-Alkyl oder substituiertes oder unsubstituiertes C₆-C₃₀-Aryl;
- q,r: unabhängig voneinander 0, 1, 2 oder 3; wobei in dem Fall, wenn q bzw. r 0 bedeuten, alle substituierbaren Positionen des Arylrests mit Wasserstoff substituiert sind,
wobei die Reste und Indices in der Gruppe der Formel (c) X‴, R⁴¹‴, R⁴²‴, R⁴³‴, R^{a}‴, R^{b}‴, q‴ und r‴ unabhängig voneinander die für die Reste und Indices der Verbindungen der allgemeinen Formel III X, R⁴¹, R⁴², R⁴³, R^{a}, R^{b}, q und r genannten Bedeutungen aufweisen. Geeignete Bedeutungen für die vorstehend genannten Reste und Gruppen Alkyl, Aryl, Heteroaryl, Substituenten mit Donor- oder Akzeptorwirkung, Alkoxy, Aryloxy, Alkylthio, Arylthio, Halogen, Amino und Amido sind vorstehend genannt.

Bevorzugte Reste und Gruppen R³⁸ bis R⁴³, R^{a} und R^{b} sind davon abhängig, in welcher Schicht der erfindungsgemäßen OLED die Verbindungen der Formel III eingesetzt werden sowie von den elektronischen Eigenschaften (Lagen der HOMOs und LUMOs) der jeweiligen in der erfindungsgemäßen OLED eingesetzten Schichten. Somit ist es möglich, durch geeignete Substitution der Verbindungen der Formel III die HOMO und LUMO-Orbitallagen an die weiteren in der erfindungsgemäßen OLED eingesetzten Schichten anzupassen und so eine hohe Stabilität der OLED und damit eine lange operative Lebensdauer und/oder eine verbesserte Effizienz zu erreichen.

Geeignete Lochblockermaterialien sind dem Fachmann bekannt. Übliche Materialien sind 2,9-Dimethyl-4,7-diphenyl-1,10-phenanthrolin (Bathocuproin, (BCP)), Bis-(2-methyl-8-chinolinato)-4-phenyl-phenylato)-aluminium(III) (BAlq), Phenothiazinderivate und 1,3,5-tris(N-Phenyl-2-benzylimidazol)-benzol) (TPBI), wobei TPBI auch als Elektronen-leitendes Material geeignet ist. Des Weiteren können auch 9-(4-tert-Butyl-phenyl)-3,6-bis(triphenylsilyl)-carbazol (CzSi) und 9-(Phenyl)-3,6-bis(triphenylsilyl)- carbazol als Lochblockermaterialien eingesetzt werden.

Neben den genannten als Lochblockermaterialien geeigneten 3,6-Disilylcarbazolen der Formel III (9-(4-tert-Butyl-phenyl)-3,6-bis(triphenylsily)-carbazol und 9-(Phenyl)-3,6-bis(triphenylsilyl)-carbazol), worin bedeuten:
- R³⁷: 4-tert-Butylphenyl - im Falle von 9-(4-tert-Butylphenyl)-3,6-bis(triphenylsilyl)-carbazol - oder unsubstituiertes Phenyl - im Falle von 9-(Phenyl)-3,6-bis(triphenylsilyl)-carbazol-
- R³⁸, R³⁹, R⁴⁰, R⁴¹, R⁴², R⁴³: unsubstituiertes Phenyl; und
- q und r: 0,
sind als Lochblockermaterialien die weiteren vorstehend genannten Verbindungen der Formel III geeignet. Bevorzugte Verbindungen der Formel III sind nachstehend genannt.

Bei den Verbindungen der Formel III handelt es sich um Disilylverbindungen, worin die Reste und Indices die folgenden Bedeutungen aufweisen:
- X: NR³⁷, S, O, PR³⁷, SO₂ oder SO; bevorzugt NR³⁷, S, O;
- R³⁷: substituiertes oder unsubstituiertes C₁-C₂₀-Alkyl, substituiertes oder unsubstituiertes C₆-C₃₀-Aryl oder substituiertes oder unsubstituiertes Heteroaryl mit 5 bis 30 Ringatomen; bevorzugt substituiertes oder unsubstituiertes C₆-C₃₀-Aryl, besonders bevorzugt substituiertes oder unsubstituiertes C₆-C₁₀-Aryl oder unsubstituiertes C₁-C₂₀-Alkyl, ganz besonders bevorzugt substituiertes oder unsubstituiertes Phenyl, wobei geeignete Substituenten vorstehend genannt sind;
- R³⁸, R³⁹, R⁴⁰, R⁴¹, R⁴², R⁴³: unabhängig voneinander substituiertes oder unsubstituiertes C₁-C₂₀-Alkyl oder substituiertes oder unsubstituiertes C₆-C₃₀-Aryl oder eine Struktur der allgemeinen Formel (c); bevorzugt bedeutet mindestens einer der Reste R³⁸, R³⁹ oder R⁴⁰ und/oder mindestens einer der Reste R⁴¹, R⁴² oder R⁴³ substituiertes oder unsubstituiertes C₆-C₃₀-Aryl, besonders bevorzugt substituiertes oder unsubstituiertes C₆-C₁₀-Aryl, ganz besonders bevorzugt substituiertes oder unsubstituiertes Phenyl, wobei geeignete Substituenten vorstehend genannt sind, und/oder einer der Reste R³⁸, R³⁹ oder R⁴⁰ und/oder einer der Reste R⁴¹, R⁴² oder R⁴³ ist ein Rest der Struktur (c);
- R^{a}, R^{b}: unabhängig voneinander substituiertes oder unsubstituiertes C₁-C₂₀-Alkyl, sub-stituiertes oder unsubstituiertes C₆-C₃₀-Aryl, subsituiertes oder unsubstituiertes Heteroaryl mit 5 bis 30 Ringatomen, oder ein Substituent mit Donor- oder Akzeptorwirkung, wobei geeignete und bevorzugte Substituenten mit Donor- oder Akzeptorwirkung vorstehend genannt sind;
- R³⁴, R³⁵ R³⁶: unabhängig substituiertes oder unsubstituiertes C₁-C₂₀-Alkyl oder substituiertes oder unsubstituiertes C₆-C₃₀-Aryl, bevorzugt substituiertes oder unsubstituiertes C₁-C₆-Alkyl oder substituiertes oder unsubstituiertes C₆-C₁₀-Aryl, wobei R³⁴, R³⁵ und R³⁶ besonders bevorzugt unabhängig voneinander substituiertes oder unsubstituiertes C₁-C₂₀-Alkyl oder substituiertes oder unsubstituiertes Phenyl bedeuten; besonders bevorzugt ist mindenstens einer der Reste R³⁴,R³⁵ oder R³⁶ substituiertes oder unsubstituiertes Phenyl, ganz besonders bevorzugt ist mindenstens einer der Reste R³⁴,R³⁵ und R³⁶ substituiertes Phenyl, wobei geeignete Substituenten vorstehend genannt sind;
- q,r: unabhängig voneinander 0, 1, 2 oder 3, wobei, wenn q bzw. r 0 sind, alle substituierbaren Positionen des Arylrests Wasserstoffatome tragen, bevorzugt 0.

In einer Ausführungsform betrifft die vorliegende Erfindung eine erfindungsgemäße organische Leuchtdiode, worin die Gruppe X in den Verbindungen der Formel III NR³⁷ bedeutet, wobei der Rest R³⁷ bereits vorstehend definiert wurde, worin mindestens einer der Reste R³⁷ bis R⁴³, R^{a} oder R^{b} in den Verbindungen der Formel III mindestens ein Heteroatom enthält. Bevorzugte Heteroatome sind N, Si, Halogen, insbesondere F oder Cl, O, S oder P. Das Heteroatom kann in Form eines Substituenten an mindestens einem der Reste R³⁷ bis R⁴³, R^{a} oder R^{b} bzw. in Form eines Teils eines Substituenten vorliegen oder in dem Grundgerüst mindestens eines der Reste R³⁷ bis R⁴³, R^{a} oder R^{b} vorliegen. Geeignete Substituenten oder Grundgerüste sind dem Fachmann bekannt und in den Definitionen der Reste R³⁷ bis R⁴³, R^{a} oder R^{b} erwähnt.

Eine bevorzugte Ausführungsform der vorliegenden Erfindung betrifft eine organische Leuchtdiode gemäß der vorliegenden Erfindung, worin mindestens einer der Reste R³⁸, R³⁹ oder R⁴⁰ und/oder mindestens einer der Reste R⁴¹, R⁴² oder R⁴³ in den Verbindungen der Formel III substituiertes oder unsubstituiertes C₆-C₃₀-Aryl bedeuten. Bevorzugte Arylreste und deren Substituenten wurden bereits vorstehend genannt.

Eine weitere Ausführungsform der vorliegenden Erfindung betrifft eine erfindungsgemäße organische Leuchtdiode, worin die Verbindung der allgemeinen Formel III eine 3,6-Disilylsubstituierte Verbindung der allgemeinen Formel lila ist: 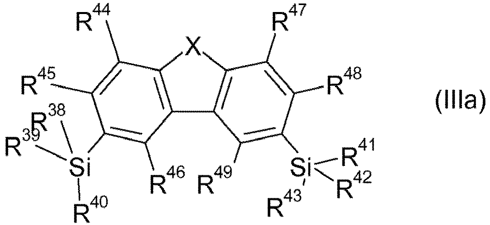 worin bedeuten:
- X: NR³⁷, S, O, PR³⁷, SO₂ oder SO; bevorzugt NR³⁷, S oder O; besonders bevorzugt NR³⁷;
- R³⁷: substituiertes oder unsubstituiertes C₁-C₂₀-Alkyl, substituiertes oder unsubstituiertes C₆-C₃₀-Aryl oder substituiertes oder unsubstituiertes Heteroaryl mit 5 bis 30 Ringatomen; bevorzugt substituiertes oder unsubstituiertes C₆-C₃₀-Aryl oder unsubstituiertes C₁-C₂₀-Alkyl, besonders bevorzugt substituiertes oder unsubstituiertes C₆-C₁₀-Aryl, ganz besonders bevorzugt substituiertes oder unsubstituiertes Phenyl, wobei geeignete Substituenten vorstehend genannt sind;
- R³⁸, R³⁹, R⁴⁰, R⁴¹, R⁴², R⁴³: unabhängig voneinander substituiertes oder unsubstituiertes C₁-C₂₀-Alkyl oder substituiertes oder unsubstituiertes C₆-C₃₀-Aryl oder eine Struktur der allgemeinen Formel (c); bevorzugt bedeutet mindestens einer der Reste R³⁸, R³⁹ oder R⁴⁰ und/oder mindestens einer der Reste R⁴¹, R⁴² oder R⁴³ substituiertes oder unsubstituiertes C₆-C₃₀-Aryl, besonders bevorzugt substituiertes oder unsubstituiertes C₆-C₁₀-Aryl, ganz besonders bevorzugt substituiertes oder unsubstituiertes Phenyl, wobei geeignete Substituenten vorstehend genannt sind, und/oder einer der Reste R³⁸, R³⁹ oder R⁴⁰ und/oder einer der Reste R⁴¹, R⁴² oder R⁴³ ist ein Rest der Struktur (c);
- R⁴⁴, R⁴⁵, R⁴⁶, R⁴⁷, R⁴⁸, R⁴⁹: unabhängig voneinander Wasserstoff oder die für R^{a} und R^{b} genannten Bedeutungen, das heißt unabhängig voneinander substituiertes oder unsubstituiertes C₁-C₂₀-Alkyl, substituiertes oder unsubstituiertes C₆-C₂₀-Aryl, substituiertes oder unsubstituiertes Heteroaryl mit 5 bis 30 Ringatomen oder ein Substituent mit Donor- oder Akzeptorwirkung, wobei geeignete Substituenten mit Donor- oder Akzeptorwirkung vorstehend genannt sind; bevorzugt Wasserstoff, substituiertes oder unsubstituiertes C₁-C₆-Alkyl, substituiertes oder unsubstituiertes C₆-C₁₀-Aryl oder SiR³⁴R³⁵R³⁶; besonders bevorzugt Wasserstoff, Methyl, Ethyl, Phenyl, CF₃ oder SiR³⁴R³⁵R³⁶ wobei R³⁴,R³⁵ und R³⁶ bevorzugt unabhängig voneinander substituiertes oder unsubstituiertes C₁-C₂₀-Alkyl oder substituiertes oder unsubstituiertes Phenyl bedeuten; besonders bevorzugt ist mindenstens einer der Reste R³⁴,R³⁵ oder R³⁶ substituiertes oder unsubstituiertes Phenyl, ganz besonders bevorzugt ist mindenstens einer der Reste R³⁴,R³⁵ und R³⁶ substituiertes Phenyl, wobei geeignete Substituenten vorstehend genannt sind;
und die weiteren Reste und Indices R³⁴, R³⁵, R³⁶ die vorstehend genannten Bedeutungen aufweisen.

In einer besonders bevorzugten Ausführungsform weisen die in den erfindungsgemäßen organischen Leuchtdioden eingesetzten Verbindungen der Formel (II) für die Reste R³⁷ bis R⁴³, R^{a} und R^{b} sowie die Gruppe X die folgenden Bedeutungen auf:
- X: NR³⁷;
- R³⁷: substituiertes oder unsubstituiertes C₆-C₃₀-Aryl, bevorzugt substituiertes oder unsubstituiertes C₆-C₁₀-Aryl, besonders bevorzugt substituiertes oder unsubstituiertes Phenyl, wobei geeignete Substituenten vorstehend genannt sind;
- R³⁸, R³⁹, R⁴⁰, R⁴¹, R⁴², R⁴³: unabhängig voneinander substiuiertes oder unsubstituiertes C₁-C₂₀-Alkyl oder substituiertes oder unsubstituiertes C₆-C₃₀-Aryl, oder eine Struktur der allgemeinen Formel (c), bevorzugt unabhängig voneinander substituiertes oder unsubstituiertes C₁-C₆-Alkyl oder substituiertes oder unsubstituiertes C₆-C₁₀-Aryl, besonders bevorzugt substituiertes oder unsubstituiertes C₁-C₆-Alkyl oder substituiertes oder unsubstituiertes Phenyl; wobei in einer Ausführungsform mindestens einer der Reste R³⁸, R³⁹ oder R⁴⁰ und/oder mindestens einer der Reste R⁴¹, R⁴² oder R⁴³ substituiertes oder unsubstituiertes C₆-C₃₀-Aryl, bevorzugt substituiertes oder unsubstituiertes C₆-C₁₀-Aryl, besonders bevorzugt substituiertes oder unsubstituiertes Phenyl, bedeutet; wobei bevorzugte Substituenten vorstehend genannt sind;
- R⁴⁴, R⁴⁵, R⁴⁶, R⁴⁷, R⁴⁸, R⁴⁹: unabhängig voneinander Wasserstoff oder die für R^{a} und R^{b} genannten Bedeutungen, das heißt unabhängig voneinander substituiertes oder unsubstituiertes C₁-C₂₀-Alkyl, substituiertes oder unsubstituiertes C₆-C₃₀-Aryl, substituiertes oder unsubstituiertes Heteroaryl mit 5 bis 30 Ringatomen oder ein Substituent mit Donor- oder Akzeptorwirkung, wobei geeignete Substituenten mit Donor- oder Akzeptorwirkung bereits vorstehend genannt sind; bevorzugt Wasserstoff, substituiertes oder unsubstituiertes C₁-C₆-Alkyl, substituiertes oder unsubstituiertes C₆-C₁₀-Aryl oder SiR³⁴R³⁵R³⁶; besonders bevorzugt Wasserstoff, Methyl, Ethyl, Phenyl, CF₃ oder SiR³⁴R³⁵R³⁶;
- R³⁴, R³⁵ R³⁶: unabhängig voneinander substituiertes oder unsubstituiertes C₁-C₂₀-Alkyl oder substituiertes oder unsubstituiertes C₆-C₃₀-Aryl, bevorzugt substituiertes oder unsubstituiertes C₁-C₆-Alkyl oder substituiertes oder unsubstituiertes C₆-C₁₀-Aryl, wobei R³⁴,R³⁵ und R³⁶ besonders bevorzugt unabhängig voneinander substituiertes oder unsubstituiertes C₁-C₂₀-Alkyl oder substituiertes oder unsubstituiertes Phenyl bedeuten; besonders bevorzugt ist mindenstens einer der Reste R³⁴,R³⁵ oder R³⁶ substituiertes oder unsubstituiertes Phenyl, ganz besonders bevorzugt ist mindenstens einer der Reste R³⁴,R³⁵ und R³⁶ substituiertes Phenyl, wobei geeignete Substituenten vorstehend genannt sind.

In einer weiteren bevorzugten Ausführungsform betrifft die vorliegende Erfindung eine organische Leuchtdiode, in der eine Verbindung der Formel III eingesetzt wird, worin der Rest R³⁷, und/oder mindestens einer der Reste aus der Gruppe R³⁸, R³⁹ und R⁴⁰ und/oder mindestens einer der Reste aus der Gruppe R⁴¹, R⁴² und R⁴³ unabhängig voneinander substituiertes oder unsubstituiertes C₆-Aryl der folgenden Formel bedeuten: 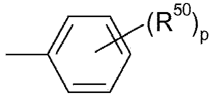 worin bedeuten
- p: 0, 1, 2, 3, 4 oder 5, bevorzugt 0, 1, 2 oder 3, besonders bevorzugt 0, 1 oder 2;
- R⁵⁰: Wasserstoff, substituiertes oder unsubstituiertes C₁-C₂₀-Alkyl, substituiertes oder unsubstituiertes C₆-C₃₀-Aryl, substituiertes oder unsubstituiertes Heteroaryl mit 5 bis 30 Ringatomen, ein Substituent mit Donor- oder Akzeptorwirkung, wobei geeignete Substituenten mit Donor- oder Akzeptorwirkung vorstehend genannt sind, oder ein Rest der allgemeinen Formel a oder b 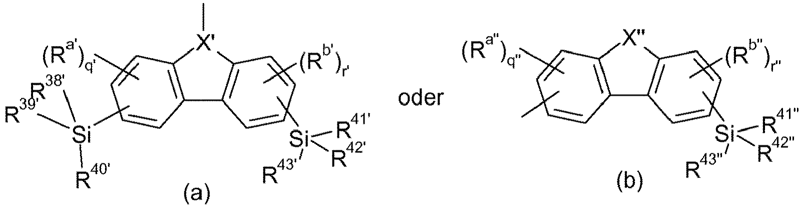
worin
- X': N oder P bedeutet, und
die Reste und Indizes X", R^{38'}, R^{39'}, R^{40'}, R^{41'}, R^{41"}, R^{42'}, R^{42"}, R^{43'}, R^{43"}, R^{a'}, R^{a"}, R^{b'}, R^{b"}, q', q", r' und r" unabhängig voneinander für die Reste und Indizes X, R³⁸, R³⁹, R⁴⁰, R⁴¹, R⁴², R⁴³, R^{a}, R^{b}, q und r genannten Bedeutungen aufweisen;
oder
einer der Reste R³⁸, R³⁹ oder R⁴⁰ und/oder einer der Reste R⁴¹, R⁴² oder R⁴³ ein Rest der allgemeinen Formel c ist 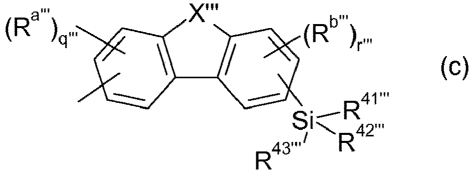 worin die Reste und Indizes X‴, R^{41‴}, R^{42‴}, R^{43‴}, R^{a‴}, R^{b‴}, q‴ und r‴ unabhängig voneinander die für die Reste und Indizes X, R⁴¹, R⁴², R⁴³, R^{a}, R^{b}, q und r genannten Bedeutungen aufweisen.

Bevorzugte Reste R⁵⁰ sind ausgewählt aus der Gruppe bestehend aus Wasserstoff, substituiertem oder unsubstituiertem C₁-C₆-Alkyl, substituiertem oder unsubstituiertem C₆-C₁₀-Aryl, substituiertem oder unsubstituiertem Heteroaryl mit 5 bis 13 Ringatomen, bevorzugt Carbazolyl, einem Substituenten mit Donor- oder Akzeptorwirkung ausgewählt aus der Gruppe bestehend aus C₁- bis C₂₀-Alkoxy, bevorzugt C₁-C₆-Alkoxy, besonders bevorzugt Ethoxy oder Methoxy; C₆-C₃₀-Aryloxy, bevorzugt C₆-C₁₀-Aryloxy, besonders bevorzugt Phenyloxy; SiR³⁴R³⁵R³⁶; Halogenresten, bevorzugt F, Cl, Br, besonders bevorzugt F oder Cl, ganz besonders bevorzugt F, halogenierten C₁-C₂₀-Alkylresten, bevorzugt halogenierten C₁₀-C₆-Alkylresten, ganz besonders bevorzugt fluorierten C₁-C₆-Alkylresten, z. B. CF₃, CH₂F, CHF₂ oder C₂F₅; Amino, bevorzugt Dimethylamino, Diethylamino oder Diphenylamino, besonders bevorzugt Diphenylamino; OH, Pseudohalogenresten, bevorzugt CN, SCN oder OCN, besonders bevorzugt CN; C(O)OC₁-C₄-Alkyl, bevorzugt -C(O)OMe, P(O)Ph₂, SO₂Ph, wobei R³⁴, R³⁵ und R³⁶ unabhängig voneinander substituiertes oder unsubstituiertes C₁- bis C₆-Alkyl oder substituiertes oder unsubstituiertes C₆- bis C₁₀-Aryl bedeuten und - im Falle von SiR³⁴R³⁵R³⁶ - bevorzugt unabhängig voneinander substituiertes oder unsubstituiertes Alkyl oder substituiertes oder unsubstituiertes Phenyl bedeuten; besonders bevorzugt ist mindenstens einer der Reste R³⁴,R³⁵ oder R³⁶ substituiertes oder unsubstituiertes Phenyl, ganz besonders bevorzugt ist mindenstens einer der Reste R³⁴,R³⁵ und R³⁶ substituiertes Phenyl, wobei geeignete Substituenten vorstehend genannt sind. Besonders bevorzugt sind die Reste R⁵⁰ unabhängig voneinander ausgewählt aus der Gruppe bestehend aus Methoxy, Phenyloxy, unsubstituiertem C₁-C₄-Alkyl, bevorzugt Methyl, halogeniertem C₁-C₄-Alkyl, bevorzugt CF₃, CHF₂, CH₂F, C₂F₅, CN, Halogen, bevorzugt F, -C(O)O-C₁-C₄-Alkyl, bevorzugt -C(O)OMe, P(O)Ph₂, und substituiertem oder unsubstituiertem Heteroaryl mit 5 bis 13 Ringatomen, bevorzugt Carbazolyl.

In einer weiteren Ausführungsform der vorliegenden Erfindung bedeuten die Indizes r und q in den Verbindungen der Formel III 0, d. h. alle substituierbaren Positionen der Arylgruppen tragen Wasserstoffatome. Für alle anderen Reste und Indizes gelten die vorstehend genannten Bedeutungen.

Die erfindungsgemäß eingesetzten Verbindungen der Formel III können in verschiedenen Schichten der erfindungsgemäßen organischen Leuchtdiode eingesetzt werden, wobei geeignete und bevorzugte Schichtfolgen in den erfindungsgemäßen OLEDs vorstehend genannt sind. In der vorliegenden Erfindung werden die Verbindungen der Formel III in der Loch-blockierenden Schicht als Loch- und/oder Excitonenblocker eingesetzt. In einer Ausführungsform betrifft die vorliegende Erfindung organische Leuchtdioden, worin die Verbindungen der Formel III in der Licht-emittierenden Schicht E als Matrix eingesetzt werden. Dabei werden die Verbindungen der Formel (III) in der Licht-emittierenden Schicht neben den Komponenten CA und CB eingesetzt. Es ist des Weiteren möglich, die Disilylcarbazole oder die Disilylbenzophosohole der Formel (III) (X = NR³⁷ oder PR³⁷) als Loch-leitendes Material CA neben der Komponente CB einzusetzen.

In einer weiteren Ausführungsform betrifft die vorliegende Erfindung eine erfindungsgemäße organische Leuchtdiode, worin die Verbindungen der Formel III in der Blockschicht für Elektronen als Elektronen/Excitonenblocker und/oder in der Loch-Injektionsschicht und/oder in der Lochleiterschicht eingesetzt werden. Es ist ebenfalls möglich, dass die Verbindungen der Formel III des Weiteren in der Licht-emittierenden Schicht C und/oder einer oder mehreren der nachstehend genannten Schichten vorliegen.

In einer weiteren Ausführungsform betrifft die vorliegende Erfindung eine erfindungsgemäße organische Leuchtdiode, worin die Verbindungen der Formel III
in der Elektronen-Injektionsschicht und/oder in der Elektronenleiterschicht eingesetzt werden. Es ist ebenfalls möglich, dass die Verbindungen der Formel III in der Licht-emittierenden Schicht C und/oder einer oder mehreren der vorstehend genannten Schichten vorliegen.

In einer weiteren Ausführungsform betrifft die vorliegende Erfindung eine erfindungsgemäße organische Leuchtdiode, worin die Verbindungen der Formel (III)
in der Elektronen-Injektionsschicht und/oder in der Elektronenleiterschicht eingesetzt werden. Es ist ebenfalls möglich, dass die Verbindungen der Formel (III) in der Licht-emittierenden Schicht C und/oder einer oder mehreren der vorstehend genannten Schichten vorliegen.

In Abhängigkeit davon, in welcher Schicht die Verbindungen der Formel III eingesetzt werden, weisen die Verbindungen der Formel III unterschiedliche bevorzugte Reste R³⁷, R³⁸, R³⁹, R⁴⁰, R⁴¹, R⁴², R⁴³, R^{a} und R^{b} und unterschiedliche Gruppen X auf. Neben der Funktion der Schicht, worin die Verbindungen der Formel III in der erfindungsgemäßen OLED eingesetzt werden können, sind die Reste R³⁷ bis R⁴³, R^{a} und R^{b} und die Gruppe X der Verbindungen der Formel III des Weiteren von den elektronischen Eigenschaften (relative Lagen der HOMOs und LUMOs) der jeweiligen in der erfindungsgemäßen OLED eingesetzten Schichten abhängig. Somit ist es möglich, durch geeignete Substitution der Verbindungen der Formel (II) die HOMO und LUMO-Orbitallagen an die weiteren in der erfindungsgemäßen OLED eingesetzten Schichten anzupassen und so eine hohe Stabilität der OLED und damit eine lange operative Lebensdauer und gute Effizienzen zu erreichen.

Die Grundsätze betreffend die relativen Lagen von HOMO und LUMO in den einzelnen Schichten einer OLED sind dem Fachmann bekannt. Im Folgenden sind die Grundsätze beispielhaft bezüglich der Eigenschaften der Blockschicht für Elektronen und der Blockschicht für Löcher im Verhältnis zur Licht-emittierenden Schicht aufgeführt:
Das LUMO der Blockschicht für Elektronen liegt energetisch höher als das LUMO der in der Licht-emittierenden Schicht eingesetzten Materialien (sowohl des Emittermaterials auch gegebenenfalls eingesetzter Matrixmaterialien). Je größer die energetische Differenz der LUMOs der Blockschicht für Elektronen und der Materialien in der Licht-emittierenden Schicht ist, desto besser sind die Elektronen- und/oder Excitonen-blockierenden Eigenschaften der Blockschicht für Elektronen. Geeignete Substitutionsmuster der als Elektronen- und/oder Excitonenblockermaterialien geeigneten Verbindungen der Formel III sind somit unter anderem abhängig von den elektronischen Eigenschaften (insbesondere der Lage des LUMOs) der in der Licht-emittierenden Schicht eingesetzten Materialien. Das HOMO der Blockschicht für Löcher liegt energetisch tiefer als die HOMOs der in der Licht-emittierenden Schicht vorliegenden Materialien (sowohl der Emittermaterialien als auch der gegebenenfalls vorliegenden Matrixmaterialien). Je größer die energetische Differenz der HOMOs der Blockschicht für Löcher und der in der Licht-emittierenden Schicht vorliegenden Materialien ist, desto besser sind die Loch- und/oder Excitonen-blockierenden Eigenschaften der Blockschicht für Löcher. Geeignete Substitutionsmuster der als Loch- und/oder Excitonenblockermaterialien geeigneten Verbindungen der Formel (II) sind somit unter anderem abhängig von den elektronischen Eigenschaften (insbesondere der Lage der HOMOs) der in der Licht-emittierenden Schicht vorliegenden Materialien.

Vergleichbare Überlegungen betreffend die relative Lage der HOMOs und LUMOs der unterschiedlichen in der erfindungsgemäßen OLED eingesetzten Schichten gelten für die weiteren gegebenenfalls in der OLED eingesetzten Schichten und sind dem Fachmann bekannt.

Bevorzugt geeignete Reste R³⁷, R³⁸, R³⁹, R⁴⁰, R⁴¹, R⁴², R⁴³, R^{a} und R^{b} der Verbindungen der Formel III in Abhängigkeit von deren Einsatz in verschiedenen Schichten der erfindungsgemäßen OLED sind nachstehend genannt. Es wird darauf hingewiesen, dass auch andere als die nachstehend genannten bevorzugten Substitutionen der Verbindungen der Formel III zum Einsatz in den verschiedenen Schichten - in Abhängigkeit von den elektronischen Eigenschaften der weiteren Schichten der OLED, insbesondere in Abhängigkeit von den elektronischen Eigenschaften der Licht-emittierenden Schicht - grundsätzlich geeignet sein können.

*Verbindungen der allgemeinen Formel III, die insbesondere für den Einsatz in der Licht-emittierenden Schicht C als Materialien neben den Komponenten CA und CB sowie für den Einsatz in der Blockschicht für Elektronen, der Loch-Injektionsschicht und*/*oder der Lochleiterschicht geeignet sind*

Eine bevorzugte Ausführungsform der vorliegenden Erfindung betrifft eine organische Leuchtdiode, worin die Verbindungen der Formel III in einer Blockschicht für Elektronen, in einer Loch-Injektionsschicht und/oder in einer Lochleiterschicht und/oder in der Licht-emittierenden Schicht C neben den Komponenten CA und CB eingesetzt werden.

Bevorzugte Verbindungen der Formel III, die in mindestens einer der vorstehend genannten Schichten eingesetzt werden können, weisen mindestens einen Rest R³⁷, R³⁸, R³⁹, R⁴⁰, R⁴¹, R⁴² oder R⁴³ auf, der substituiertes oder unsubstituiertes C₁-C₂₀-Alkyl, Heteroaryl mit 5 bis 30 Ringatomen, substituiertes oder unsubstituiertes C₆-C₃₀-Aryl, alkylsubstituiertes C₆-C₃₀-Aryl (wobei "alkylsubstituiertes" mit C₁-C₂₀-Alkyl substituiertes C₆-C₃₀-Aryl bedeutet), mit mindestens einem Substituenten mit Donorwirkung substituiertes C₆-C₃₀-Aryl oder mit Heteroaryl mit 5 bis 30 Ringatomen substituiertes C₆-C₃₀-Aryl oder ein Substituent mit Donorwirkung oder, im Falle von R³⁸, R³⁹, R⁴⁰, R⁴¹, R⁴² oder R⁴³, Wasserstoff ist.

Geeignete Substituenten mit Donorwirkung (elektronenschiebende Reste) sind ausgewählt aus der Gruppe bestehend aus substituiertem oder unsubstituiertem C₁-C₆-Alkyl, bevorzugt Methyl, substituiertem oder unsubstituiertem C₆-C₁₀-Aryl, substituiertem oder unsubstituiertem elektronenreichem Heteroaryl mit fünf bis 30 Ringatomen, bevorzugt ausgewählt aus der Gruppe bestehend aus Carbazolyl, Pyrrolyl, Imidazolyl, Pyrazolyl, Triazolyl, Oxazolyl, Thiophenyl, bevorzugt Carbazolyl und Thiophenyl, C₁-C₂₀-Alkoxy, bevorzugt C₁-C₆-Alkoxy, besonders bevorzugt Methoxy und Ethoxy, C₆-C₃₀-Aryloxy, bevorzugt C₆-C₁₀-Aryloxy, besonders bevorzugt Phenyloxy, C₁-C₂₀-Alkylthio, bevorzugt C₁-C₆-Alkylthio, besonders bevorzugt -SCH₃, C₆-C₃₀-Arylthio, bevorzugt C₆-C₁₀-Arylthio, besonders bevorzugt -SPh, F, SiR³⁴R³⁵R³⁶, wobei R³⁴, R³⁵ und R³⁶ bevorzugt donor-substituierte Phenylgruppen bedeuten, Amino (-NR³⁴R³⁵), bevorzugt Diphenylamino, Phosphin (-PR³⁴R³⁵), Hydrazinresten, OH, Donor-substituierten Vinylgruppen, wobei R³⁴, R³⁵ und R3¹⁶ die vorstehend genannten Bedeutungen aufweisen und bevorzugt Donor-substituierte Phenylgruppen bedeuten.

Ganz besonders bevorzugte Substituenten mit Donorwirkung sind ausgewählt aus der Gruppe bestehend aus Diphenylamino, Carbazolyl, Methoxy, Phenoxy, wobei Methoxy und Carbazolyl insbesondere ganz besonders bevorzugt sind.

Besonders bevorzugt handelt es sich bei dem mindestens einen Rest, der in den vorstehend genannten Schichten eingesetzt wird, um einen mit mindestens einem Substituenten mit Donorwirkung und/oder mindestens einem Heteroarylrest mit 5 bis 30 Ringatomen substituierten C₆-Arylrest der Formel (d) 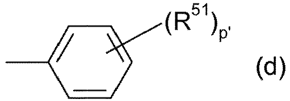 worin bedeuten:
- p': 1, 2, 3, 4 oder 5, bevorzugt 1, 2 oder 3, besonders bevorzugt 1 oder 2, und
- R⁵¹: jeweils unabhängig voneinander substituiertes oder unsubstituiertes C₁-C₆-Alkyl, bevorzugt Methyl, substituiertes oder unsubstituiertes C₆-C₁₀-Aryl, C₁-C₂₀-Alkoxy, bevorzugt C₁-C₆-Alkoxy, besonders bevorzugt Methoxy und Ethoxy, C₆-C₃₀-Aryloxy, bevorzugt C₆-C₁₀-Aryloxy, besonders bevorzugt Phenyloxy, C₁-C₂₀-Alkylthio, bevorzugt C₁-C₆-Alkylthio, besonders bevorzugt -SCH₃, C₆-C₃₀-Arylthio, bevorzugt C₆-C₁₀-Arylthio, besonders bevorzugt -SPh, SiR³⁴R³⁵R³⁶, wobei R³⁴, R³⁵ und R³⁶ die vorstehend genannten Bedeutungen aufweisen und bevorzugt Donor-substituierte Phenylgruppen bedeuten, Amino (-NR³⁴R³⁵), bevorzugt Diphenylamino, Amido -NR³⁴ (C = O (R³⁵), Phosphin (-PR³⁴R³⁵), Hydrazinreste, OH, Donor-substituierte Vinylgruppen, wobei R³⁴, R³⁵ und R³⁶ die vorstehend genannten Bedeutungen aufweisen und bevorzugt Donor-substituierte Phenylgruppen bedeuten, oder R⁵¹ bedeutet substituiertes oder unsubstituiertes elektronenreiches Heteroaryl mit fünf bis 30 Ringatomen, bevorzugt ausgewählt aus der Gruppe bestehend aus Carbazolyl, Pyrrolyl, Imidazolyl, Pyrazolyl, Triazolyl, Oxazolyl, Thiophenyl, besonders bevorzugt Carbazolyl und Pyrrolyl.

Bevorzugte Gruppen R⁵¹ sind ausgewählt aus der Gruppe bestehend aus Methoxy, Ethoxy, Phenoxy, wobei Methoxy insbesondere ganz besonders bevorzugt ist, Carbazolyl, Pyrrolyl, Imidazolyl, Pyrazolyl, Triazolyl, Oxazolyl und Thiophenyl, wobei Methoxy, Phenyloxy, Carbazolyl und NR³⁴R³⁵ wobei R³⁴ und R³⁵ Phenyl oder Tolyl bedeuten, ganz besonders bevorzugt sind.

Besonders bevorzugt weisen die in den vorstehend genannten Schichten eingesetzten Verbindungen der Formel (III) mindestens einen Rest R³⁷, R³⁸, R³⁹, R⁴⁰, R⁴¹, R⁴² oder R⁴³ auf, ausgewählt aus der Gruppe bestehend aus 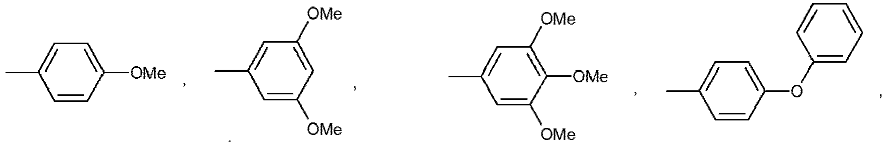 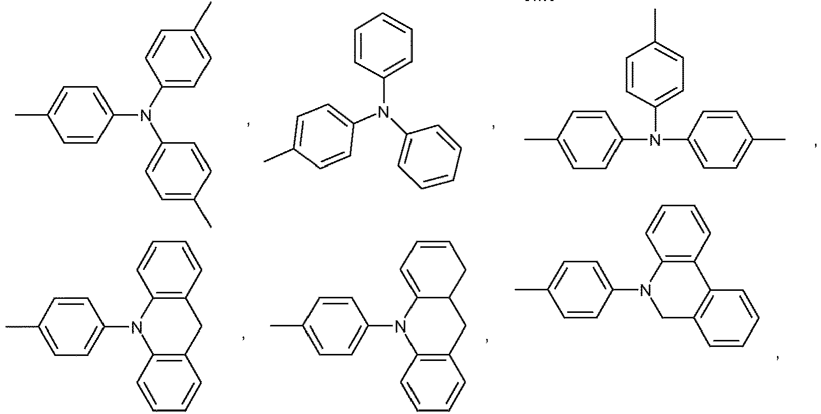 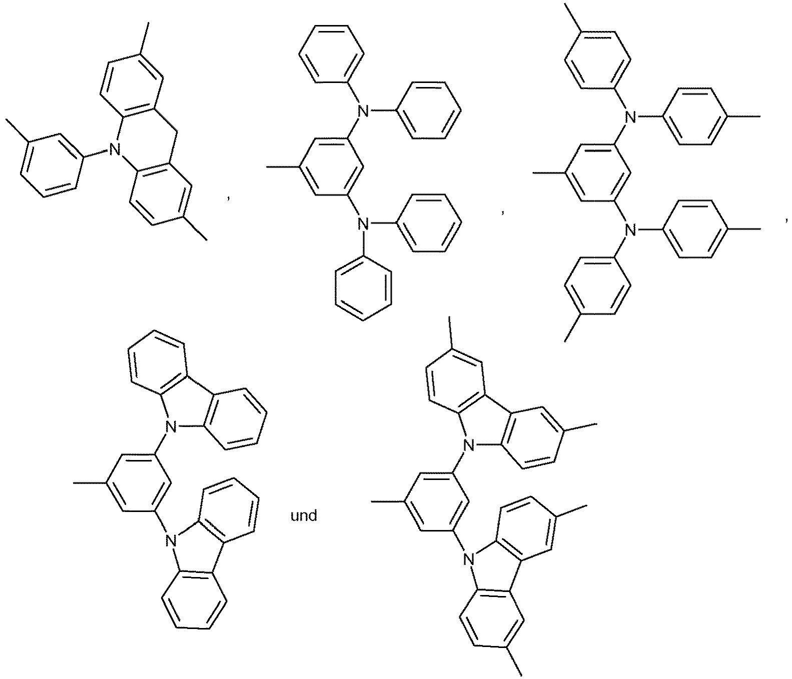 In einer bevorzugten Ausführungsform ist mindestens der Rest R¹ ein mit mindestens einem Substituenten mit Donorwirkung und/oder mindestens einem Heteroarylrest mit 5 bis 30 Ringatomen substituierter C₆-Arylrest der Formel (d);
und die Reste R³⁸, R³⁹, R⁴⁰, R⁴¹, R⁴² und R⁴³ bedeuten bevorzugt Phenyl, Methyl oder mit Methoxy oder Phenyloxy substituiertes Phenyl.

*Einsatz der Verbindungen der Formel III*
*in einer Blockschicht für Löcher, und zusätzlich einer Elektronen-Injektionsschicht und*/*oder einer Elektronenleiterschicht*
und/oder der Licht-emittierenden Schicht C
neben den Komponenten CA und CB

Ein weiterer Gegenstand der vorliegenden Erfindung betrifft eine erfindungsgemäße organische Leuchtdiode, worin in mindestens einer der Schichten ausgewählt aus Lichtemittierender Schicht C neben den Komponenten CA und CB, Blockschicht für Löcher, Elektronen-Injektionsschicht und Elektronenleiterschicht mindestens eine Verbindung der Formel III vorliegt. Auf jeden Fall liegt erfindungsgemäß in der Blockschicht für Löcher eine Verbindung der Formel III vor.

Bevorzugte in den vorstehend genannten Schichten eingesetzte Verbindungen der Formel III weisen mindestens einen Rest R³⁷, R³⁸, R³⁹, R⁴⁰, R⁴¹, R⁴² oder R⁴³ auf, der mit mindestens einem Substituenten mit Akzeptorwirkung (elektronenziehender Rest) substituiertes C₁- bis C₂₀-Alkyl, mit mindestens einem Substituenten mit Akzeptorwirkung substituiertes C₆-C₃₀-Aryl, mit mindestens einem Heteroarylrest mit 5 bis 30 Ringatomen substituiertes C₆-C₃₀-Aryl oder ein Substituent mit Akzeptorwirkung ist.

Geeignete Substituenten mit Akzeptorwirkung (elektronenziehende Reste) sind ausgewählt aus der Gruppe bestehend aus elektronenarmen Heteroarylen mit 5 bis 30 Ringatomen, Carbonyl (-CO(R³⁴)), Carbonylthio (-C = O (SR³⁴)), Carbonyloxy (-C = O (OR³⁴)), Oxycarbonyl (-OC = O (R³⁴)), Thiocarbonyl (-SC = O(R³⁴)), OH, Halogen, mit Halogen substituiertem C₁-C₂₀-Alkyl, Pseudohalogenresten, Amido (-C = O (NR³⁴), , Phosphonat (-P(O) (OR³⁴)₂), Phosphat (-OP (O) (OR³⁴)₂), Phosphinoxid (-P(O)R³⁴R³⁵), Sulfonyl (-S(O)₂R³⁴) Sulfonat (-S(O)₂OR³⁴), Sulfat (-OS(O)₂OR³⁴), Sulfoxid (-S(O)R³⁴), Sulfonamid (-S(O)₂NR³⁴R³⁵), NO₂, Boronsäureestern (-OB(OR³⁴)₂, Imino (-C = NR³⁴R³⁵)), Hydrazinresten, Hydrazolresten, Oximresten, Nitroso-Gruppen, Diazo-Gruppen, Sulfoximinen, SiR³⁴R³⁵R³⁶, Boranresten, Stannanresten, akzeptorsubstituierten Vinylgruppen, Boroxine und Borazinen, wobei R³⁴, R³⁵ und R³⁶ substituiertes oder unsubstituiertes C₁-C₂₀-Alkyl, bevorzugt substituiertes oder unsubstituiertes C₁-C₆-Alkyl, oder substituiertes oder unsubstituiertes C₆-C₃₀-Aryl, bevorzugt substituiertes oder unsubstituiertes C₆-C₁₀-Aryl bedeuten.

Bevorzugte Substituenten mit Akzeptorwirkung sind ausgewählt aus der Gruppe bestehend aus Halogen, bevorzugt F, mit Halogen substituiertem Alkyl, bevorzugt CF₃, CH₂F, CHF₂, C₂F₅, C₃F₃H₄, Pseudohalogen, bevorzugt CN, Carbonyloxy (-C = O (OR¹⁴)), bevorzugt -C = O (OCH₃), Phosphinoxid, bevorzugt P(O)Ph₂ und Sulfonyl, bevorzugt S(O)₂Ph₂.

Besonders bevorzugt handelt es sich bei dem mindestens einen Rest, der in den vorstehend genannten Schichten eingesetzt wird, um einen substituierten C₆-Arylrest der Formel (e) 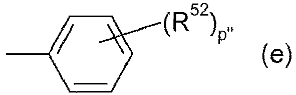 worin bedeuten:
- p": 1, 2, 3, 4 oder 5, bevorzugt 1, 2 oder 3, besonders bevorzugt 1 oder 2; und
- R⁵²: Carbonyl (-CO(R³⁴)), Carbonylthio (-C = O (SR³⁴)), Carbonyloxy (-C = O (OR³⁴)), O-xycarbonyl (-OC = O (R³⁴)), Thiocarbonyl (-SC = O(R³⁴)), OH, Halogen, mit Halogen substituiertes C₁-C₂₀-Alkyl, Pseudohalogenreste, Amido (-C = O (NR³⁴), , Phosphonat (-P(O) (OR³⁴)₂), Phosphat (-OP (O) (OR³⁴)₂), Phosphinoxid (-P(O)R³⁴R³⁵), Sulfonyl (-S(O)₂R³⁴), Sulfonat (-S(O)₂OR³⁴), Sulfat (-OS(O)₂OR³⁴), Sulfoxid (-S(O)R³⁴), Sulfonamid (-S(O)₂NR³⁴R³⁵), NO₂, Boronsäureester (-OB(OR³⁴)₂, Imino (-C = NR³⁴R³⁵)), Hydrazinreste, Hydrazolreste, Oximreste, Nitroso-Gruppen, Diazo-Gruppen, Sulfoximine, SiR³⁴R³⁵R³⁶, Boranreste, Stannanreste, akzeptorsubstituierte Vinylgruppen, Boroxine und Borazine, wobei R³⁴, R³⁵ und R³⁶ substituiertes oder unsubstituiertes C₁-C₂₀-Alkyl, bevorzugt substituiertes oder unsubstituiertes C₁-C₆-Alkyl, oder substituiertes oder unsubstituiertes C₆-C₃₀-Aryl, bevorzugt substituiertes oder unsubstituiertes C₆-C₁₀-Aryl bedeuten; bevorzugt Halogen, bevorzugt F, mit Halogen substituiertem Alkyl, bevorzugt CF₃, CH₂F, CHF₂, C₂F₅, C₃F₃H₄, Pseudohalogen, bevorzugt CN, Carbonyloxy (-C = O (OR³⁴)), bevorzugt -C = O (OCH₃), Phosphinoxid, bevorzugt P(O)Ph₂ und Sulfonyl, bevorzugt S(O)₂Ph₂; oder R⁵² bedeutet substituiertes oder unsubstituiertes elektronenarmes Heteroaryl mit fünf bis 30 Ringatomen, bevorzugt ausgewählt aus der Gruppe bestehend aus Pyridin, Pyrimidin und Triazin.

Besonders bevorzugt weisen die in den vorstehend genannten Schichten eingesetzten Verbindungen der Formel III mindestens einen Rest R³⁷, R³⁸, R³⁹, R⁴⁰, R⁴¹, R⁴² oder R⁴³ auf, ausgewählt aus der Gruppe bestehend aus: 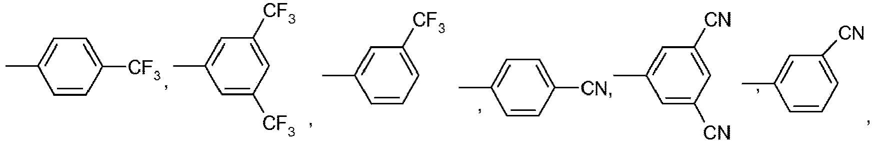 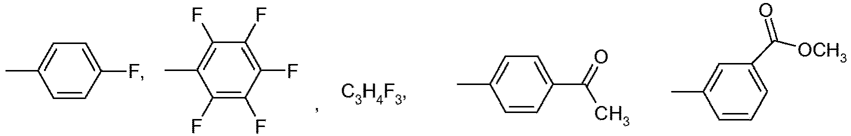 und

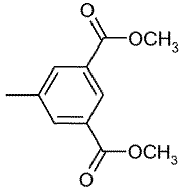

### Herstellung der erfindungsgemäß eingesetzten Verbindungen der Formel III

Die Verbindungen der Formel III können grundsätzlich nach dem Fachmann bekannten Verfahren hergestellt werden, z. B. können Carbazole der Formel III (X = NR³⁷) thermisch oder photochemisch durch oxidativen Ringschluss aus Diphenylamin (oder geeignet substituierten Derivaten davon) und gegebenenfalls nachfolgende Substitution, z. B. am Stickstoff, hergestellt werden. Des Weiteren können die Carbazole der Formel (II) ausgehend von den geeignet substituierten Tetrahydrocarbazolen durch Oxidation erhalten werden. Eine typische Carbazol-Synthese ist die Borsche-Drechsel-Cyclisierung (Borsche, Ann., 359, 49 (1908); Drechsel, J. prakt. Chem., [2], 38, 69, 1888). Die vorstehend erwähnten Tetrahydrocarbozole können gemäß dem Fachmann bekannten Verfahren hergestellt werden, z. B. durch Kondensation von ggf. geeignet substituiertem Phenylhydrazin mit ggf. geeignet substituiertem Cyclohexanon, wobei das entsprechende Imin erhalten wird. In einem anschließenden Schritt erfolgt eine Säure katalysierte Umlagerungs- und Ringschlussreaktion, wobei das entsprechende Tetrahydrocarbozol erhalten wird. Es ist ebenfalls möglich, die Herstellung des Imins und die Umlagerungs- und Ringschlussreaktion in einem Schritt durchzuführen. Dieses wird - wie vorstehend erwähnt - zu dem gewünschten Carbazol oxidiert.

Die Herstellung der Verbindungen der Formel III erfolgt bevorzugt ausgehend von dem ensprechenden Grundgerüst der Formel IV: 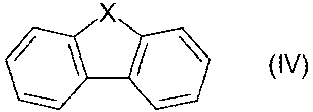 wobei X NR³⁷, SO, SO₂, S, O oder PR³⁷ oder NH oder PH bedeutet. Geignete Grundgerüste der Formel (III) sind entweder kommerziell erhältlich (insbesondere in den Fällen, wenn X SO, SO₂, S, O, NH oder PH bedeutet) oder nach dem Fachmann bekannten Verfahren herstellbar.

Die Reste R³⁷ können in dem Fall, dass X NH oder PH bedeutet, vor oder nach dem Einbringen der Reste R^{a}, R^{b}, SiR³⁸R³⁹R⁴⁰ und SiR⁴¹R⁴²R⁴³, soweit die Reste R^{a} und R^{b} in den Verbindungen der Formel III vorliegen, bzw. zur Einführung der Reste R^{a}, R^{b}, SiR³⁸R³⁹R⁴⁰ und SiR⁴¹R⁴²R⁴³ geeigneten Vorläuferverbindungen, eingebracht werden. Somit sind drei Varianten - im Fall von X = NR³⁷ und PR³⁷ - möglich:

### Variante a)

ia) Herstellung einer zur Einführung der Reste R^{a}, R^{b}, SiR³⁸R³⁹R⁴⁰ und SiR⁴¹R⁴²R⁴³ geeigneten Vorläuferverbindung,
iia) Einbringen des Rests R³⁷,
iiia) Einbringen der Reste R^{a}, R^{b}, soweit vorhanden, sowie der Reste SiR³⁸R³⁹R⁴⁰ und SiR⁴¹R⁴²R⁴³.

### Variante b)

Variante b) ist insbesondere dann bevorzugt, wenn R³⁷ substituiertes oder unsubstituiertes C₁-C₂₀-Alkyl oder unsubstituiertes C₆-C₃₀-Aryl oder C₁-C₂₀-Alkyl-substituiertes C₆-C₃₀-Aryl ist.
ib) Einbringen des Rests R³⁷,
iib) Herstellung einer zur Einführung der Reste R^{a}, R^{b}, SiR³⁸R³⁹R⁴⁰ und SiR⁴¹R⁴²R⁴³ geeigneten Vorläuferverbindung,
iiib) Einbringen der Reste R^{a}, R^{b}, soweit vorhanden, sowie der Reste SiR³⁸R³⁹R⁴⁰ und SiR⁴¹R⁴²R⁴³.

### Variante c)

ic) Herstellung einer zur Einführung der Reste R^{a}, R^{b}, SiR³⁸R³⁹R⁴⁰ und SiR⁴¹R⁴²R⁴³ geeigneten Vorläuferverbindung,
iic) Einbringen der Reste R^{a}, R^{b}, soweit vorhanden, sowie der Reste SiR³⁸R³⁹R⁴⁰ und SiR⁴¹R⁴²R⁴³,
iiic) Einbringen des Rests R³⁷.

In dem Fall, dass X in Formel (III) NR³⁷, SO, SO₂, S, O oder PR³⁷ bedeutet, entfällt der Schritt "Einbringen des Rests R³⁷" , so dass das Verfahren die folgenden Schritte (*Variante d*) umfasst:
id) Herstellung einer zur Einführung der Reste R^{a}, R^{b}, SiR³⁸R³⁹R⁴⁰ und SiR⁴¹R⁴²R⁴³ geeigneten Vorläuferverbindung,
iid) Einbringen der Reste R^{a}, R^{b}, soweit vorhanden, sowie der Reste SiR³⁸R³⁹R⁴⁰ und SiR⁴¹R⁴²R⁴³.

### Schritt ia), iib), ic) und id)

Als Vorläuferverbindungen zur Einführung der Reste R^{a}, R^{b}, SiR³⁸R³⁹R⁴⁰ und SiR⁴¹R⁴²R⁴³ sind insbesondere die entsprechenden halogenierten, bevorzugt bromierten Verbindungen geeignet, wobei die Halogenierung der entsprechenden Grundgerüste nach dem Fachmann bekannten Verfahren erfolgen kann. Besonders bevorzugt erfolgt eine Bromierung mit Br₂ in Eisessig oder Chloroform bei tiefen Temperaturen, z.B. 0°C. Geeignete Verfahren sind z.B. für X= NPh in M. Park, J.R. Buck, C.J. Rizzo, Tetrahedron, 1998, 54, 12707-12714 und für X= S in W. Yang et al., J. Mater. Chem. 2003, 13, 1351 beschrieben. Des Weiteren sind einige bromierte Produkte kommerziell erhältlich.

### Schritt iia), ib) und iiic)

Die Einführung des Restes R³⁷ erfolgt nach dem Fachmann bekannten Verfahren.

Die Einführung des Restes R³⁷ erfolgt bevorzugt durch Umsetzung eines geeigneten halogenierten oder nicht halogenierten Grundgerüsts, worin X NH oder PH bedeutet, mit einem Alkylhalogenid bzw. Arylhalogenid bzw. Herteroarylhalogenid der Formel R³⁷-Hal, wobei R³⁷ bereits vorstehend definiert wurde und Hal F, Cl, Br oder I, bevorzugt Br, I oder F, bedeutet.

Bevorzugt erfolgt die Einführung des Restes R³⁷ durch Umsetzung des geeigneten halogenierten oder nicht halogenierten Grundgerüsts, worin X NH oder PH bedeutet, mit einem Alkyl-, Aryl- oder Heteroarylfluorid in Anwesenheit von NaH in DMF (nucleophile Substitution) oder durch Umsetzung mit einem Alkyl-, Aryl- oder Heteroarylbromid oder -iodid unter Cu/Base oder Pd Katalyse.

### Schritt iiia), iiib), iic) und iid)

Die Herstellung der gewünschen silylierten Verbindungen der Formel III erfolgt ausgehend von den halogenierten Vorläuferverbindungen im Allgemeinen durch Halogen/Metallaustausch und anschließende Silylierung nach dem Fachmann bekannten Verfahren.

Weitere bevorzugte Verbindungen der Formel III und weitere Angaben zu geeigneten Herstellungsverfahren der Verbindungen der Formel III sind in der zeitgleich angemeldeten nicht vorveröffentlichten Anmeldung mit dem Titel "Organische Leuchtdioden enthaltend Carben-Übergangsmetall-Komplex-Emitter und mindestens eine Verbindung ausgewählt aus Disilylcarbazolen, Disilyldibenzofuranen, Disilyldibenzothiophenen, Disilyldibenzophospholen, Disilyldibenzothiophen-S-oxiden und Disilyldibenzothiophen-S,S-dioxiden" genannt.

In einer bevorzugten Ausführungsform werden die Verbindungen der Formel III Excitonenblocker in der Loch- und/oder Elektronen blockierenden Schicht und/oder als weiteres Material in der Licht-emittierenden Schicht C enthaltend die Komponenten CA und CB eingesetzt. In dem Fall, wenn die Verbindung der Formel III ein Disilylcarbazol oder Disilyldibenzophosphol ist (X in Formel III bedeutet NR¹ oder PR¹), kann die Verbindung der Formel III in einer weiteren Ausführungsform als Komponente CA neben der Komponente CB in der Licht-emittierenden Schicht C eingesetzt werden.

Gegenstand der vorliegenden Erfindung ist eine erfindungsgemäße organische Leuchtdiode worin mindestens eine Verbindung der Formel III in der Loch-blockierenden Schicht als Lochblockermaterial und/oder Excitonenblockermaterial vorliegt. Bevorzugt wird in der organischen Leuchtdiode als Loch-leitendes Material CA mindestens eine Verbindung der Formel III, worin X NR¹ oder PR¹ bedeutet, eingesetzt.

Bevorzugte als Lochblocker geeignete Verbindungen der Formel III wurden bereits vorstehend genannt. Diese Materialien können gleichzeitig als Excitonenblocker in der Loch-blockierenden Schicht eingesetzt werden. In einer bevorzugten Ausführungsform werden 9-(4-tert-Butyl-phenyl)-3,6-bis(triphenylsilyl)-carbazol (CzSi) und 9-(Phenyl)-3,6-bis(triphenylsilyl)- carbazol als Lochblockermaterialien eingesetzt.

Im Allgemeinen haben die verschiedenen Schichten der erfindungsgemäßen OLED übliche, dem Fachmann bekannte Schichtdicken. Geeignete Schichtdicken sind z.B.: Anode A 50 bis 500 nm, bevorzugt 100 bis 200 nm; Loch-leitende Schicht B 5 bis 100 nm, bevorzugt 20 bis 80 nm; Licht-emittierende Schicht C 1 bis 100 nm, bevorzugt 10 bis 80 nm; Elektronen-leitende Schicht D 5 bis 100 nm, bevorzugt 20 bis 80 nm; Kathode E 20 bis 1000 nm, bevorzugt 30 bis 500 nm. Die gegebenenfalls des Weiteren in der erfindungsgemäßen OLED vorliegende Loch-blockierende Schicht hat im Allgemeinen eine Dicke von 2 bis 100 nm, bevorzugt 5 bis 50 nm. Es ist möglich, dass die Elektronen-leitende Schicht und/oder die Loch-leitende Schicht größere Dicken als die angegebenen Schichtidicken aufweisen, wenn sie elektrisch dotiert sind.

Die Herstellung der erfindungsgemäßen OLED kann nach dem Fachmann bekannten Methoden erfolgen. Im Allgemeinen wird die OLED durch aufeinanderfolgende Dampfabscheidung (Vapor Deposition) der einzelnen Schichten auf ein geeignetes Substrat hergestellt. Geeignete Substrate sind z. B. Glas, anorganische Halbleiter oder Polymerfilme. Für die Dampfabscheidung können übliche Techniken eingesetzt werden, die thermische Verdampfung, chemical vapor deposition (CVD), physical vapor deposition (PVD) und andere. In einem alternativen Verfahren können organische Schichten der OLED aus Lösungen oder Dispersionen in geeigneten Lösungsmitteln aufgetragen werden, wobei dem Fachmann bekannte Beschichtungstechniken angewendet werden. Die erfindungsgemäß bevorzugt in der Loch-leitenden Schicht B und in der Licht-emittierenden Schicht C eingesetzten Übergangsmetallcarbenkomplexe der allgemeinen Formel I werden bevorzugt mittels Dampfabscheidung aufgebracht.

### Zum Einsatz in OLEDs geeignete Mischungen

Wie bereits vorstehend erwähnt, wurde erfindungsgemäß überraschenderweise gefunden, dass OLEDs mit einer überraschend langen Lebensdauer bereitgestellt werden können, wenn die Licht-emittierende Schicht C aus einer Mischung aus mindestens einem Loch-leitenden Material CA und mindestens einem Phosphoreszenz-Emitter CB aufgebaut ist. Im Allgemeinen enthält die in der erfindungsgemäßen OLED eingesetzte Licht-emittierende Schicht C 5 bis 99 Gew.-%, bevorzugt 20 bis 97 Gew.-%, besonders bevorzugt 50 bis 95 Gew.-%, ganz besonders bevorzugt 70 bis 95 Gew.-% mindestens eines Loch-leitenden Materials CA und 1 bis 95 Gew.-%, bevorzugt 3 bis 80 Gew.-%, besonders bevorzugt 5 bis 60 Gew.-%, ganz besonders bevorzugt 5 bis 30 Gew.-% mindestens eines Phosphoreszenz-Emitters CB, wobei die Gesamtmenge des mindestens einen Loch-leitenden Materials CA und des mindestens einen Phosphoreszenz-Emitters CB 100 Gew.-% beträgt. Es wurde gefunden, dass bereits geringe Mengen des Phosphoreszenz-Emitters ausreichen, um eine erfindungsgemäße OLED mit guten Effizienzen zu erhalten. In einer ganz besonders bevorzugten Ausführungsform enthält die Licht-emittierende Schicht C der erfindungsgemäßen OLED somit 5 bis 20 Gew.-% mindestens eines Phosphoreszenz-Emitters CB und 80 bis 95 Gew.-% mindestens eines Loch-leitenden Materials CA, wobei die Gesamtmenge des mindestens einen Loch-leitenden Materials CA und des mindestens einen Phosphoreszenz-Emitters CB 100 Gew.-% beträgt. Es ist grundsätzlich möglich, dass die Licht-emittierende Schicht C neben den Komponenten CA und CB weitere funktionelle Materialien enhält. Z.B. kann die Licht-emittierende Schicht C des Weiteren mindestens eine Verbindung der Formel III enthalten, wobei bevorzugte Verbindungen der Formel III vorstehend genannt sind.

Bevorzugt sind Mischungen enthaltend mindestens zwei verschiedene Carbenkomplexe CA und CB, wobei die Bandlücke des Carbenkomplexes CA größer ist als die Bandlücke des Carbenkomplexes CB. Bevorzugt weist der Carbenkomplex CB eine Bandlücke von ≥ 2,5 eV, besonders bevorzugt 2,5 eV bis 3,4 eV, ganz besonders bevorzugt 2,6 eV bis 3,2 eV und insbesondere ganz besonders bevorzugt 2,8 eV bis 3,2 eV auf. Bei dem Carbenkomplex CB handelt es sich in einer insbesondere ganz besonders bevorzugten Ausführungsform um einen blaues Licht emittierenden Carbenkomplex.

Bevorzugt handelt es sich bei den Carbenkomplexen CA und CB jeweils um Carbenkomplexe der allgemeinen Formel I, wobei die Carbenkomplexe CA und CB unterschiedlich sind. Geeignete und bevorzugte Carbenkomplexe der Formel I sowie geeignete Mengenverhältnisse der Carbenkomplexe CA und CB sind bereits vorstehend genannt.

Bevorzugt sind auch Mischungen enthaltend mindestens einen Carbenkomplex in Kombination mit mindestens einem von dem ersten Carbenkomplex verschiedenen Loch-leitenden Material oder in Kombination mit mindestens einem von dem ersten Carbenkomplex verschiedenen Phosphoreszenz-Emitter, wobei die Mischungen mindestens einen Carbenkomplex CB und mindestens eine Verbindung der Formel III gemäß Anspruch 10, worin X NR¹ oder PR¹ bedeutet, als Loch-leitendes Material CA enthalten.

Es wurde gefunden, dass bei Einsatz von Mischungen, enthaltend mindestens ein Loch-leitendes Material CA und mindestens einen Phosphoreszenz-Emitter CB als Licht-emittierende Schicht in OLEDs eine deutliche Verlängerung der Lebensdauer der OLED erreicht werden kann.

Bevorzugte Mischungen sind Mischungen, wie sie vorstehend definiert wurden, wobei besonders bevorzugt Mischungen von zwei Carbenkomplexen CA und CB eingesetzt werden, wobei die Bandlücke des als Loch-leitendes Material eingesetzten Carbenkomplexes CA größer ist als die Bandlücke des als Phosphoreszenz-Emitter eingesetzten Carbenkomplexes CB. Bevorzugte Carbenkomplexe sowie geeignete Mengen des mindestens einen Loch-leitenden Materials und des mindestens einen Phosphoreszenz-Emitters in der Licht-emittierenden Schicht sind bereits vorstehend genannt.

Die nachfolgenden Beispiele erläutern die Erfindung zusätzlich.

### Beispiele

### Beispiel: Herstellung eines OLED

Das als Anode verwendete ITO-Substrat wird zuerst mit kommerziellen Reinigungsmitteln für die LCD-Produktion (Deconex^{®} 20NS und Neutralisationsmittel 250RGAN-ACID^{®}) und anschließend in einem Aceton/Isopropanol-Gemisch im Ultraschallbad gesäubert. Zur Beseitigung möglicher organischer Rückstände wird das Substrat in einem Ozonofen weitere 25 Minuten einem kontinuierlichen Ozonfluss ausgesetzt. Diese Behandlung verbessert auch die Lochinjektionseigenschaften des ITOs.

Danach werden die nachfolgend genannten organischen Materialien mit einer Rate von ca. 0.5-5 nm/min bei etwa 10⁻⁷ mbar auf das gereinigte Substrat aufgedampft. Als Lochleiter und Excitonenblocker wird Ir(dpbic)₃ mit einer Dicke von 30 nm auf das Substrat aufgebracht. 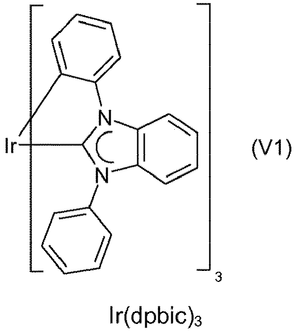 (zur Herstellung siehe Ir-Komplex (7) in der Anmeldung WO 2005/019373).

Anschließend wird eine Mischung aus 30 Gew.-% der Verbindung Ir(cn-pmbic)₃ 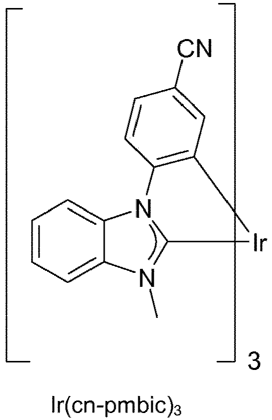 und 70 Gew.-% der Verbindung Ir(dpbic)₃ in einer Dicke von 20 nm aufgedampft, wobei erstere Verbindung als Emitter, letztere als Matrixmaterial fungiert.

Anschließend wird das Material 9-(Phenyl)-3,6-bis(triphenylsilyl)-9H-carbazol mit einer Dicke von 5 nm als Excitonen- und Lochblocker aufgedampft.

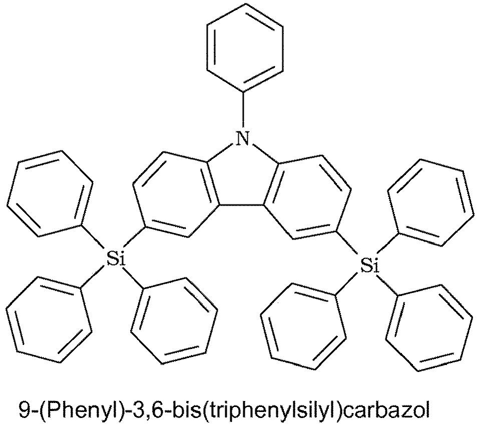

Als nächstes wird ein Elektronentransporter TPBI (1,3,5-tris(N-Phenyl-2-benzylimidazol)-benzol) in einer Dicke von 50 nm, eine 0,75 nm dicke Lithiumfluorid-Schicht und abschließend eine 110 nm dicke Al-Elektrode aufgedampft.

Zur Charakterisierung des OLEDs werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibration mit einem Luminanzmeter in photometrische Größen umgerechnet werden. Zur Bestimmung der Lebensdauer wird das OLED bei einer konstanten Stromdichte von 3.2 mA/cm² betrieben und die Abnahme der Lichtleistung aufgezeichnet. Die Lebensdauer ist als diejenige Zeit definiert, die zur Abnahme der Leuchtdichte auf die Hälfte der anfänglichen Leuchtdichte verstreicht.

Zum Vergleich wurde eine OLED mit einem elektronenleitenden Wirtsmaterial hergestellt. Der Aufbau gestaltete sich wie folgt: 30 nm Ir(DPBIC)₃, eine 20 nm dicke Mischung aus 30 % Ir(CN-PMBIC)₃ und 70 % eines elektronenleitenden Wirts, TPBI in einer Dicke von 50 nm, eine 0,75 nm dicke Lithiumfluorid-Schicht und abschließend 110 nm Aluminium.

Die Lebensdauer der erfindungsgemäßen OLED ist gegenüber der Vergleichs-OLED um den Faktor 50 verbessert.

## Patentansprüche

1. Organische Leuchtdiode umfassend,
i) eine Anode A;
ii) eine Loch-leitende Schicht B, aufgebaut aus mindestens einem Loch-leitenden Material;
iii) eine Licht-emittierende Schicht C;
iv) eine Elektronen-leitende Schicht D; und
v) eine Kathode E;
wobei die Schichten A, B, C, D und E in der vorstehend genannten Reihenfolge angeordnet sind und zwischen den Schichten A und B, B und C, C und D und/oder D und E eine oder mehrere weitere Schichten angeordnet sein können, wobei die Licht-emittierende Schicht C mindestens ein Loch-leitendes Material CA und mindestens einen Phosphoreszenz-Emitter CB enthält,
wobei zwischen der Licht-emittierenden Schicht C und der Elektronen-leitenden Schicht D in direktem Kontakt zu der Licht-emittierenden Schicht C eine Loch-blockierende Schicht, aufgebaut aus mindestens einem Lochblockermaterial und/oder Excitonenblockermaterial, vorliegt, **dadurch gekennzeichnet, dass** mindestens eine Verbindung der Formel III in der Loch-blockierenden Schicht als Lochblockermaterial und/oder Excitonenblockermaterial vorliegt, 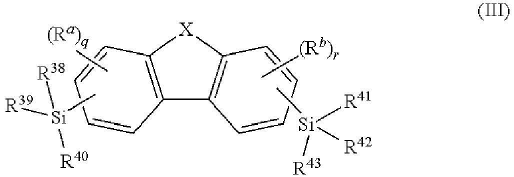 worin bedeuten:
X NR³⁷, S, O, PR³⁷, SO₂ oder SO;
R³⁷ substituiertes oder unsubstituiertes C₁-C₂₀-Alkyl, substituiertes oder unsubstituiertes C₆-C₃₀-Aryl oder substituiertes oder unsubstituiertes Heteroaryl mit 5 bis 30 Ringatomen;
R³⁸, R³⁹, R⁴⁰, R⁴¹, R⁴², R⁴³ unabhängig voneinander substituiertes oder unsubstituiertes C₁-C₂₀-Alkyl oder substituiertes oder unsubstituiertes C₆-C₃₀-Aryl oder eine Struktur der allgemeinen Formel (c) 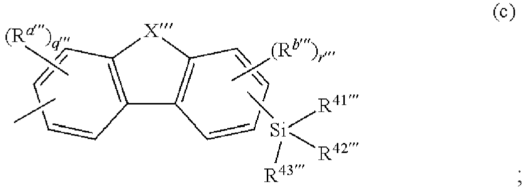
R^{a}, R^{b} unabhängig voneinander substituiertes oder unsubstituiertes C₁-C₂₀-Alkyl, substituiertes oder unsubstituiertes C₆-C₃₀-Aryl, substituiertes oder unsubstituiertes Heteroaryl mit 5 bis 30 Ringatomen oder ein Substituent mit Donor- oder Akzeptorwirkung ausgewählt aus der Gruppe bestehend aus: C₁-C₂₀-Alkoxy, C₆- C₃₀-Aryloxy, C₁-C₂₀-Alkylthio, C₆-C₃₀-Arylthio, SiR³⁴R³⁵R³⁶, Halogenresten, halogenierten C₁-C₂₀-Alkylresten, Carbonyl (-CO(R³⁴)), Carbonylthio (-C=O(SR³⁴)), Carbonyloxy (-C=O(OR³⁴)), Oxycarbonyl (-OC=O(R³⁴)), Thiocarbonyl (-SC=O(R³⁴)), Amino (-NR³⁴R³⁵), OH, Pseudohalogenresten, Amido (-C=O(NR³⁴)), -NR³⁴C=O(R³⁵), Phosphonat (-P(O)(OR³⁴)₂), Phosphat (-OP(O)(OR³⁴)₂), Phosphin (-PR³⁴R³⁵), Phosphinoxid (-P(O)R³⁴₂), Sulfat (-OS(O)₂OR³⁴), Sulfoxid (-S(O)R³⁴), Sulfonat (-S(O)₂OR³⁴), Sulfonyl (-S(O)₂R³⁴), Sulfonamid (- S(O)₂NR³⁴R³⁵), NO₂, Boronsäureestern (-OB(OR³⁴)₂), Imino (-C=NR³⁴R³⁵)), Boranresten, Stannanresten, Hydrazinresten, Hydrazonresten, Oximresten, Nitroso-Gruppen, Diazo-Gruppen, Vinylgruppen, Sulfoximinen, Alanen, Germanen, Boroximen und Borazinen;
R³⁴, R³⁵, R³⁶ unabhängig voneinander substituiertes oder unsubstituiertes C₁-C₂₀-Alkyl oder substituiertes oder unsubstituiertes C₆-C₃₀-Aryl; und
q, r unabhängig voneinander 0, 1, 2 oder 3; wobei in dem Fall, wenn q bzw. r 0 bedeuten, alle substituierbaren Positionen des Arylrests mit Wasserstoff substituiert sind,
wobei die Reste und Indices in der Gruppe der Formel (c) X‴, R⁴¹‴, R⁴²‴, R⁴³‴, R^{a}‴ , R^{b}‴, q‴ und r‴ unabhängig voneinander die für die Reste und Indices der Verbindungen der allgemeinen Formel III X, R⁴¹, R⁴², R⁴³, R^{a}, R^{b}, q und r genannten Bedeutungen aufweisen,
wobei das mindestens eine Loch-leitende Material der Loch-leitenden Schicht B und das mindestens eine Loch-leitende Material CA der Licht-emittierenden Schicht C einen Carbenkomplex enthalten,
wobei die Carbenkomplexe der Loch-leitenden Materialien in den Schichten B und C gleich oder verschieden sein können,
und die Bandlücke der als Loch-leitendes Material eingesetzten Carbenkomplexe größer ist als die Bandlücke des mindestens einen Phosphoreszenz-Emitters CB.

2. Organische Leuchtdiode nach Anspruch 1, **dadurch gekennzeichnet, dass** das HOMO des mindestens einen Loch-leitenden Materials der Loch-leitenden Schicht B und das HOMO des in der Licht-emittierenden Schicht C vorliegenden mindestens einen Loch-leitenden Materials CA einen Abstand von der Austrittsarbeit der Anode A von ≤ 1 eV aufweisen.

3. Organische Leuchtdiode nach einem der Ansprüche 1 bis 2, **dadurch gekennzeichnet, dass** die Bandlücke des Phosphoreszenz-Emitters CB in der Licht-emittierenden Schicht ≥ 2,5 eV ist, bestimmt mittels Ultraviolett-Photonen-Spektroskopie (UPS).

4. Organische Leuchtdiode nach einem der Ansprüche 1 bis 3, **dadurch gekennzeichnet, dass** der mindestens eine Phosphoreszenz-Emitter CB mindestens ein Element ausgewählt aus den Gruppen IB, IIB, IIIB, IVB, VB, VIB, VIIB, VIII, den Lanthaniden und IIIA des Periodensystems der Elemente (CAS-Version) enthält.

5. Organische Leuchtdiode nach einem der Ansprüche 1 bis 4, **dadurch gekennzeichnet, dass** der mindestens eine Phosphoreszenz-Emitter CB ein Carbenkomplex ist.

6. Organische Leuchtdiode nach Anspruch 5, **dadurch gekennzeichnet, dass** der Carbenkomplex ein Übergangsmetallcarbenkomplex der allgemeinen Formel I ist 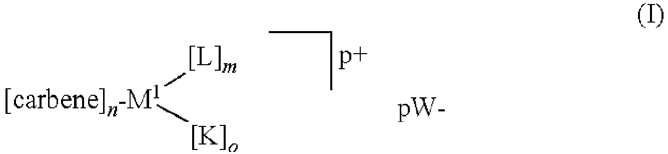 worin die Symbole die folgenden Bedeutungen aufweisen:
M¹ Metallatom ausgewählt aus der Gruppe bestehend aus Übergangsmetallen der Gruppen IB, IIB, IIIB, IVB, VB, VIB, VIIB, VIII, den Lanthaniden und IIIA des Periodensystems der Elemente (CAS-Version) in jeder für das entsprechende Metall möglichen Oxidationsstufe;
carben Carbenligand, der neutral oder monoanionisch und mono-, bi-, oder tridentat sein kann; bei dem Carbenliganden kann es sich auch um einen Bis- oder Triscarbenliganden handeln;
L mono- oder dianionischer Ligand, der mono- oder bidentat sein kann;
K neutraler mono- oder bidentater Ligand;
n Zahl der Carbenliganden, wobei n mindestens 1 ist und die Carbenliganden in dem Komplex der Formel I bei n > 1 gleich oder verschieden sein können;
m Zahl der Liganden L, wobei m 0 oder ≥ 1 sein kann und die Liganden L bei m > 1 gleich oder verschieden sein können;
o Zahl der Liganden K, wobei o 0 oder ≥ 1 sein kann und die Liganden K bei o > 1 gleich oder verschieden sein können;
p Ladung des Komplexes: 0, 1, 2, 3 oder 4; und
W⁻ monoanionisches Gegenion;
wobei die Summe n + m + o und p von der Oxidationsstufe und Koordinationszahl des eingesetzten Metallatoms, der Ladung des Komplexes und von der Zähnigkeit der Liganden carben, L und K sowie von der Ladung der Liganden carben und L abhängig ist, mit der Bedingung, dass n mindestens 1 ist.

7. Organische Leuchtdiode nach Anspruch 6, **dadurch gekennzeichnet, dass** L ein monoanionischer Ligand ist.

8. Organische Leuchtdiode nach Anspruch 6 oder 7, **dadurch gekennzeichnet, dass** n 1 bis 6 ist.

9. Organische Leuchtdiode nach einem der Ansprüche 6 bis 8, **dadurch gekennzeichnet, dass** m 0 bis 5 ist.

10. Organische Leuchtdiode nach einem der Ansprüche 6 bis 9, **dadurch gekennzeichnet, dass** o 0 bis 5 ist.

11. Organische Leuchtdiode nach einem der Ansprüche 1 bis 10, **dadurch gekennzeichnet, dass** zwischen der Loch-leitenden Schicht B und der Licht-emittierenden Schicht C eine Elektronen-blockierende Schicht, aufgebaut aus mindestens einem Elektronenblockermaterial und/oder Excitonenblockermaterial, vorliegt.

12. Organische Leuchtdiode nach einem der Ansprüche 1 bis 11, **dadurch gekennzeichnet, dass** das HOMO des in der Loch-blockierenden Schicht als das mindestens eine Lochblockermaterial und/oder Excitonenblockermaterial verwendeten Materials energetisch tiefer liegt als die HOMOs der in der Licht-emittierenden Schicht C vorliegenden Materialien.

## Claims

1. An organic light-emitting diode comprising
i) an anode A;
ii) a hole-conducting layer B formed from at least one hole-conducting material;
iii) a light-emitting layer C;
iv) an electron-conducting layer D; and
v) a cathode E;
wherein the layers A, B, C, D and E are arranged in the aforementioned sequence and one or more additional layers may be arranged between layers A and B, B and C, C and D and/or D and E, wherein the light-emitting layer C comprises at least one hole-conducting material CA and at least one phosphorescent emitter CB,
wherein a hole-blocking layer formed from at least one hole blocking material and/or exciton blocking material is present between the light-emitting layer C and the electron-conducting layer D in direct contact to the light-emitting layer C, wherein at least one compound of formula III is present in the hole-blocking layer as hole blocking material and/or excition blocking material, 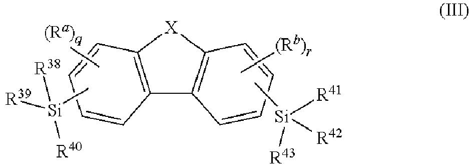 in which:
X is NR³⁷, S, O, PR³⁷, SO₂ or SO;
R³⁷ is substituted or unsubstituted C₁-C₂₀-alkyl, substituted or unsubstituted C₆-C₃₀-aryl, or substituted or unsubstituted heteroaryl having from 5 to 30 ring atoms;
R³⁸, R³⁹, R⁴⁰, R⁴¹, R⁴², R⁴³ are each independently substituted or unsubstituted C₁-C₂₀-alkyl, or substituted or unsubstituted C₆-C₃₀-aryl, or a structure of the general formula (c) 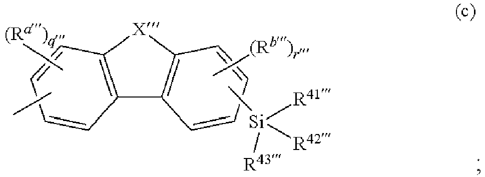 wherein R^{a}, R^{b} are each independently substituted or unsubstituted C₁-C₂₀-alkyl, substituted or unsubstituted C₆-C₃₀-aryl, or substituted or unsubstituted heteroaryl having from 5 to 30 ring atoms, or a substituent with donor or acceptor action selected from the group consisting of: C₁-C₂₀-alkoxy, C₆-C₃₀ aryloxy, C₁-C₂₀-alkylthio, C₆-C₃₀-arylthi0, SiR³⁴R³⁵R³⁶, halogen radicals, halogenated C₁-C₂₀-alkyl radicals, carbonyl (-CO(R³⁴)), carbonylthio (-C=O(SR³⁴)), carbonyloxy (-C=O(OR³⁴)), oxycarbonyl (-OC=O(R³⁴)), thiocarbonyl (-SC=O(R³⁴)), amino (-NR³⁴R³⁵), OH, pseudohalogen radicals, amido (-C=O(NR³⁴)), -NR³⁴C=O(R³⁵), phosphonate (-P(O)(OR³⁴)₂, phosphate (-OP(O)(OR³⁴)₂), phosphine (-PR³⁴R³⁵), phosphine oxide (-P(O)R³⁴₂), sulfate (-OS(O)₂OR³⁴), sulfoxide (S(O)R³⁴), sulfonate (-S(O)₂OR³⁴), sulfonyl (-S(O)₂R³⁴), sulfonamide (-S(O)₂NR³⁴R³⁵), NO₂, boronic acid esters (-OB(OR³⁴)₂), imino (-C=NR³⁴R³⁵)), borane radicals, stannane radicals, hydrazine radicals, hydrazone radicals, oxime radicals, nitroso groups, diazo groups, vinyl groups, sulfoximines, alanes, germanes, boroximes and borazines;
R³⁴R³⁵, R³⁶ are each independently substituted or unsubstituted C₁-C₂₀-alkyl, or substituted or unsubstituted C₆-C₃₀-aryl; and
q, r are each independently 0, 1, 2 or 3; where, in the case when q or r is 0, all substitutable positions of the aryl radical are substituted by hydrogen,
wherein the radicals and indices in the group of the formula (c) X‴, R⁴¹‴, R⁴²‴, R⁴³‴, R^{a}‴, R^{b}‴, q‴ and r‴ are each independently as defined for the radicals and indices of the compounds of the general formula III X, R⁴¹, R⁴², R⁴³, R^{a}, R^{b}, q and r,
wherein the at least one hole-conducting material of the hole-conducting layer B and the at least one hole-conducting material CA of the light-emitting layer C comprise a carbene complex,
wherein the carbene complexes of the hole-conducting materials in layers B and C may be the same or different,
and the band gap of the carbene complexes used as the hole-conducting material is greater than the band gap of the at least one phosphorescent emitter CB.

2. The organic light-emitting diode according to claim 1, wherein the HOMO of the at least one hole-conducting material of the hole-conducting layer B and the HOMO of the at least one hole-conducting material CA present in the light-emitting layer C have a separation from the work function of the anode A of ≦ 1 eV.

3. The organic light-emitting diode according to any one of claims 1 to 2, wherein the band gap of the phosphorescent emitter CB in the light-emitting layer is ≧2.5 eV, determined via Ultraviolet-Photon-Spectroscopy (UPS).

4. The organic light-emitting diode according to any one of claims 1 to 3, wherein the at least one phosphorescent emitter CB comprises at least one element selected from groups IB, IIB, IIIB, IVB, VB, VIIB, VIIB, VIII, the lanthanides and IIIA of the Periodic Table of the Elements (CAS version).

5. The organic light-emitting diode according to any one of claims 1 to 4, wherein the at least one phosphorescent emitter is a carbene complex.

6. The organic light-emitting diode according to claim 5, wherein the carbene complex is a transition metal-carbene complex of the general formula I 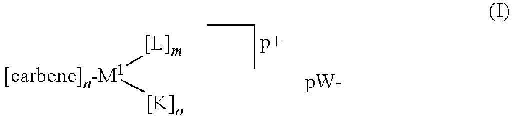 in which the symbols are each defined as follows:
M¹ is a metal atom selected from the group consisting of transition metals of groups IB, IIB, IIIB, IVB, VB, VIIB, VIIB, VIII, the lanthanides and IIIA of the Periodic Table of the Elements (CAS version) in any oxidation state possible for the particular metal;
carbene is a carbene ligand which may be uncharged or monoanionic and mono-, bi- or tridentate; the carbene ligand may also be a bis- or triscarbene ligand;
L is a mono- or dianionic ligand, which may be mono- or bidentate;
K is an uncharged mono- or bidentate ligand;
n is the number of carbene ligands, wherein n is at least 1, and the carbene ligands in the complex of the formula I when n>1 may be the same or different;
m is the number of ligands L, wherein m may be 0 or ≧1, and the ligands L when m>1 may be the same or different;
o is the number of ligands K, wherein o may be 0 or ≧1, and the ligands K when o>1 may be the same or different;
p is the charge of the complex: 0, 1, 2, 3 or 4; and
W⁻ is a monoanionic counterion;
wherein the sum of n+m+o and p depends on the oxidation state and coordination number of the metal atom used, the charge of the complex and on the denticity of the ligands carbene, L and K, and on the charge of the ligands carbene and L, with the condition that n is at least 1.

7. The organic light-emitting diode according to claim 6 wherein L is a monoanionic ligand.

8. The organic light-emitting diode according to claim 6 or 7, wherein n is from 1 to 6.

9. The organic light-emitting diode according to any one of claims 6 to 8, wherein m is from 0 to 5.

10. The organic light-emitting diode according to any one of claims 7 to 10, wherein o is from 0 to 5.

11. The organic light-emitting diode according to any one of claims 1 to 10, wherein an electron-blocking layer formed from at least one electron blocking material and/or exciton blocking material is present between the hole-conducting layer B and the light-emitting layer C.

12. The organic light-emitting diode according to any one of claims 1 to 11, wherein the HOMO of the material used as the at least one hole blocking material and/or exciton blocking material in the hole-blocking layer is energetically lower than the HOMOs of the materials present in the light-emitting layer C.

## Revendications

1. Diode électroluminescente organique comprenant,
i) une anode A ;
ii) une couche B de conduction par trous, composée d'au moins un matériau de conduction par trous ;
iii) une couche C d'émission de lumière ;
iv) une couche D de conduction d'électrons ; et
v) une cathode E ;
les couches A, B, C, D et E étant disposées dans l'ordre indiqué ci-dessus et une ou plusieurs couches supplémentaires pouvant être disposées entre les couches A et B, B et C, C et D et/ou D et E, la couche C d'émission de lumière contenant au moins un matériau CA de conduction par trous et au moins un émetteur de phosphorescence CB,
une couche de blocage de trous, constituée d'au moins un matériau de blocage de trous et/ou d'un matériau de blocage d'excitons, étant présente entre la couche C d'émission de lumière et la couche D de conduction d'électrons en contact direct avec la couche C d'émission de lumière, **caractérisée en ce qu'**au moins un composé de formule III est présent dans la couche de blocage de trous en tant que matériau de blocage de trous et/ou matériau de blocage d'excitons, 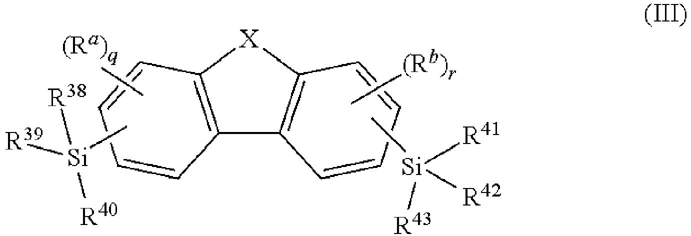 dans laquelle :
X représente NR³⁷, S, O, PR³⁷, SO₂ ou SO ;
R³⁷ représente un alkyle en C₁ à C₂₀ substitué ou non substitué, un aryle en C₆ à C₃₀ substitué ou non substitué ou un hétéroaryle substitué ou non substitué ayant de 5 à 30 atomes cycliques ;
R³⁸, R³⁹, R⁴⁰, R⁴¹, R⁴², R⁴³ représentent, indépendamment les uns des autres, un alkyle en C₁ à C₂₀ substitué ou non substitué ou un aryle en C₆ à C₃₀ substitué ou non substitué, ou une structure de formule générale (c) 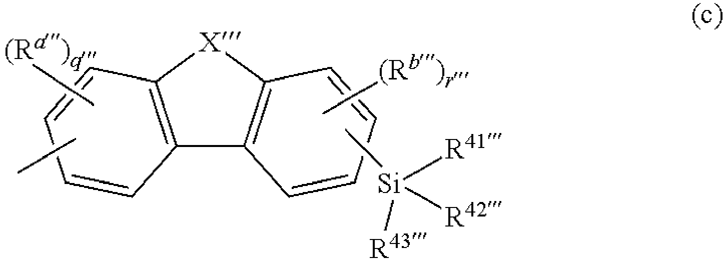
R^{a}, R^{b} représentent, indépendamment l'un de l'autre, un alkyle en C₁ à C₂₀ substitué ou non substitué, un aryle en C₆ à C₃₀ substitué ou non substitué, un hétéroaryle substitué ou non substitué ayant de 5 à 30 atomes cycliques, ou un substituant à effet donneur ou accepteur choisi dans le groupe constitué par : alcoxy en C₁ à C₂₀, aryloxy en C₆ à C₃₀, alkylthio en C₁ à C₂₀, arylthio en C₆ à C₃₀, SiR³⁴R³⁵R³⁶, radicaux halogène, radicaux alkyle halogénés en C₁ à C₂₀, carbonyle (-CO(R³⁴)), carbonylthio (-C=O(SR³⁴)), carbonyloxy (-C=O(OR³⁴)), oxycarbonyle (-OC=O(R³⁴)), thiocarbonyle (-SC=O(R³⁴)), amino (-NR³⁴R³⁵), OH, radicaux pseudohalogène, amido (-C=O(NR³⁴)), -NR³⁴C=O(R³⁵), phosphonate (-P(O)(OR³⁴)₂), phosphate (-OP(O)(OR³⁴)₂), phosphine (-PR³⁴R³⁵), oxyde de phosphine (-P(O)R³⁴₂), sulfate (-OS(O)₂OR³⁴), sulfoxyde (-S(O)R³⁴), sulfonate (-S(O)₂OR³⁴), sulfonyle (-S(O)₂R³⁴), sulfonamide (- S(O)₂NR³⁴R³⁵), NO₂, esters d'acide borique (-OB(OR³⁴)₂), imino (-C=NR³⁴R³⁵)), radicaux de borane, radicaux de stannane, radicaux d'hydrazine, radicaux d'hydrazone, radicaux d'oxime, groupes nitroso, groupes diazo, groupes vinyle, sulfoximines, alanes, germanes, boroximes et borazines ;
R³⁴, R³⁵, R³⁶ représentent indépendamment les uns des autres un alkyle en C₁ à C₂₀ substitué ou non substitué ou un aryle en C₆ à C₃₀ substitué ou non substitué ; et
q, r sont indépendamment l'un de l'autre égaux à 0, 1, 2 ou 3 ; dans le cas où q ou r est égal à 0, toutes les positions substituables du radical aryle sont substituées par de l'hydrogène,
les radicaux et indices dans le groupe de formule (c) X‴, R⁴¹‴, R⁴²‴, R⁴³‴, R^{a}‴, R^{b}‴, q‴ et r'" ayant, indépendamment les uns des autres, les significations mentionnées ci-dessus pour les radicaux et indices des composés de formule générale III X, R⁴¹, R⁴², R⁴³, R^{a}, R^{b}, q et r,
ledit au moins un matériau de conduction par trous de la couche B de conduction par trous et ledit au moins un matériau CA de conduction par trous de la couche C d'émission de lumière contenant un complexe de carbène,
les complexes de carbène des matériaux de conduction par trous dans les couches B et C pouvant être identiques ou différents,
et la bande interdite des complexes de carbène utilisés en tant que matériau de conduction par trous étant supérieure à la bande interdite dudit au moins un émetteur de phosphorescence CB.

2. Diode électroluminescente organique selon la revendication 1, **caractérisée en ce que** la HOMO dudit au moins un matériau de conduction par trous de la couche B de conduction par trous et la HOMO dudit au moins un matériau CA de conduction par trous présent dans la couche C d'émission de lumière présentent, par rapport au travail de sortie de l'anode A, un écart ≤ 1 eV.

3. Diode électroluminescente organique selon l'une des revendications 1 à 2, **caractérisée en ce que** la bande interdite de l'émetteur de phosphorescence CB dans la couche d'émission de lumière est ≥ 2,5 eV, déterminée par spectroscopie de photons ultraviolets (UPS).

4. Diode électroluminescente organique selon l'une des revendications 1 à 3, **caractérisée en ce que** ledit au moins un émetteur de phosphorescence CB contient au moins un élément choisi parmi les groupes IB, IIB, IIIB, IVB, VB, VIB, VIIB, VIII, les lanthanides et IIIA du tableau périodique des éléments (version CAS).

5. Diode électroluminescente organique selon l'une quelconque des revendications 1 à 4, **caractérisée en ce que** ledit au moins un émetteur de phosphorescence CB est un complexe de carbène.

6. Diode électroluminescente organique selon la revendication 5, **caractérisée en ce que** le complexe de carbène est un complexe métal de transition-carbène de formule générale I : 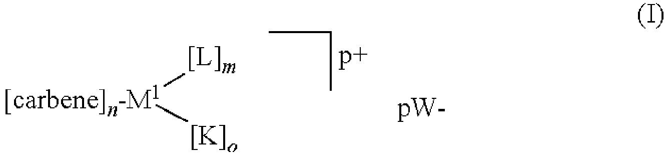 dans laquelle les symboles ont les significations suivantes :
M¹ représente un atome de métal choisi dans le groupe constitué par les métaux de transition des groupes IB, IIB, IIIB, IVB, VB, VIB, VIIB, VIII, les lanthanides et IIIA du tableau périodique des éléments (version CAS) dans chacun des degrés d'oxydation possibles pour le métal correspondant ;
carbène représente le ligand carbène, qui peut être neutre ou monoanionique et mono-, bi-, ou tridenté ; le ligand carbène peut également être un ligand bis- ou tris-carbène ;
L représente un ligand mono- ou dianionique, qui peut être mono- ou bidenté ;
K représente un ligand neutre mono- ou bidenté ;
n représente le nombre de ligands carbènes, n étant au moins égal à 1 et les ligands carbènes dans le complexe de la formule I pouvant être identiques ou différents lorsque n > 1 ;
m représente le nombre de ligands L, m pouvant être égal à 0 ou ≥ 1 et les ligands L peuvent être identiques ou différents lorsque m > 1 ;
o représente le nombre de ligands K, o pouvant être égal à 0 ou ≥ 1 et les ligands K pouvant être identiques ou différents lorsque o > 1 ;
p représente la charge du complexe : 0, 1, 2, 3 ou 4 ; et
W⁻ représente un contre-ion monoanionique ;
la somme n + m + o et p dépendant du degré d'oxydation et de l'indice de coordination de l'atome de métal utilisé, de la charge du complexe et de la denticité des ligands carbène, de L et K ainsi que de la charge des ligands carbène et de L, à la condition que n soit au moins égal à 1.

7. Diode électroluminescente organique selon la revendication 6, **caractérisée en ce que** L est un ligand monoanionique.

8. Diode électroluminescente organique selon la revendication 6 ou la revendication 7, **caractérisée en ce que** n est compris entre 1 et 6.

9. Diode électroluminescente organique selon l'une quelconque des revendications 6 à 8, **caractérisée en ce que** m est compris entre 0 et 5.

10. Diode électroluminescente organique selon l'une des revendications 6 à 9, **caractérisée en ce que** o est compris entre 0 et 5.

11. Diode électroluminescente organique selon l'une des revendications 1 à 10, **caractérisée en ce qu'**une couche de blocage d'électrons constituée d'au moins un matériau de blocage d'électrons et/ou d'un matériau de blocage d'excitons, est présente entre la couche B de conduction par trous et la couche C d'émission de lumière.

12. Diode électroluminescente organique selon l'une des revendications 1 à 11, **caractérisée en ce que** la HOMO du matériau utilisé dans la couche de blocage de trous en tant qu'au moins un matériau de blocage de trous et/ou matériau de blocage d'excitons se situe énergétiquement plus bas que les HOMO des matériaux présents dans la couche C d'émission de lumière.
